# EUROPEAN PATENT APPLICATION

(11) **EP 2 557 906 A1**
(43) Date of publication of application: **13.02.2013**
(21) Application number: 11766008.4
(22) Date of filing: 08.04.2011
(51) Int. Cl.: H05K 3/10, H05K 3/00

(54) **METHOD OF FORMING MICROSTRUCTURES, LASER IRRADIATION DEVICE, AND SUBSTRATE**

(30) Priority: 08.04.2010 JP 2010089510
(71) Applicant: Fujikura, Ltd., Tokyo 135-8512 (JP)
(72) Inventor: WAKIOKA, Hiroyuki, Sakura-shi Chiba 285-8550 (JP)
(74) Representative: Cabinet Plasseraud
(86) International application number: PCT/JP2011/058886
(87) International publication number: WO 2011/126108

(57) **Abstract**

A microstructure forming method includes a step A of irradiating a region of a substrate, in which a hole-shaped or groove-shaped microstructure is to be formed, with a circularly or elliptically polarized laser beam having a pulse width of which the pulse duration is on the order of picoseconds or shorter, and scanning a focal point at which the laser beam converges to form a modified region, and a step B of performing an etching process on the substrate in which the modified region is formed and removing the modified region to form a microstructure.

## Description

### TECHNICAL FIELD

The present invention relates to a method of forming microstructures in a substrate using a laser beam, a laser irradiation device used in the method, and a substrate manufactured using the method. More particularly, the present invention relates to a method of forming micro-holes in a substrate using a laser beam, a laser irradiation device used in the method, and a substrate manufactured using the method.
Priority is claimed on Japanese Patent Application No. 2010-089510, filed April 8, 2010, the content of which is incorporated herein by reference.

### BACKGROUND ART

Conventionally, as a method of electrically connecting a plurality of devices that are mounted on a first principal surface (one principal surface) and a second principal surface (the other principal surface) of a substrate, a method of forming a microstructure such as a micro-hole that penetrates through both principal surfaces of the substrate or a micro-groove near the surface of the substrate and filling an electrically conductive substance in the micro-hole or the micro-groove to form an interconnection has been used. For example, Patent Document 1 discloses an interposer substrate that includes a through-hole interconnection that is formed by filling an electrically conductive substance in a micro-hole that has a portion that extends in a direction different from the thickness direction of the substrate.

An example of a method of forming a microstructure such as a micro-hole and a micro-groove in such an interconnection substrate includes a method of modifying a part of a substrate such as glass using a laser and then removing a modified region by etching. Specifically, first, a femtosecond laser is used as a light source, the laser is irradiated on the substrate with the focal point of the laser converging on an inner region of the substrate to be modified, the focal point is moved to scan the region to be modified. In this way, a modified region having a predetermined shape is formed in the substrate. Subsequently, by a wet-etching method of immersing the substrate in which the modified region is formed in a predetermined chemical solution, the modified region is removed from the substrate, whereby a microstructure such as a micro-hole or a micro-groove is formed.

### PRIOR ART DOCUMENTS

### PATENT DOCUMENTS

[Patent Document 1] Japanese Unexamined Patent Application, First Publication No. 2006-303360

### DISCLOSURE OF INVENTION

### PROBLEMS TO BE SOLVED BY THE INVENTION

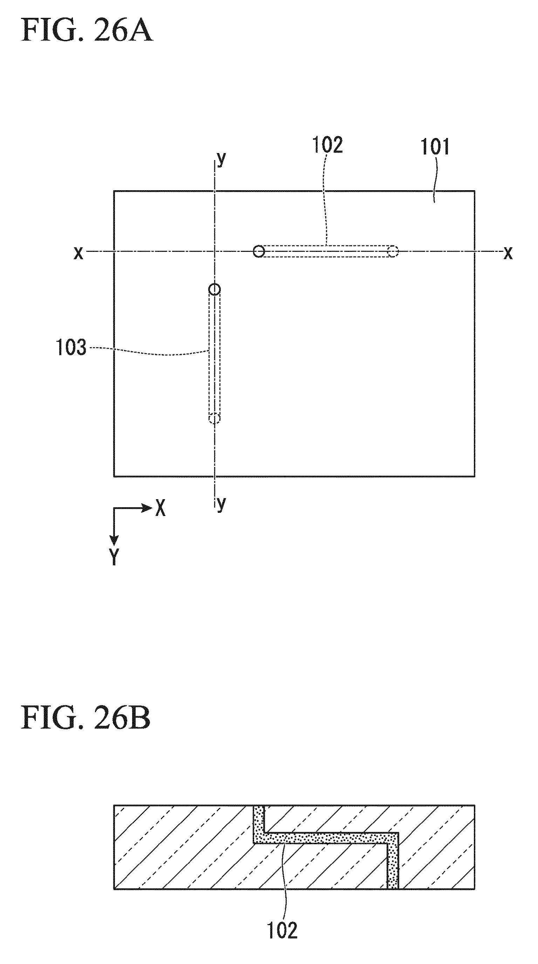

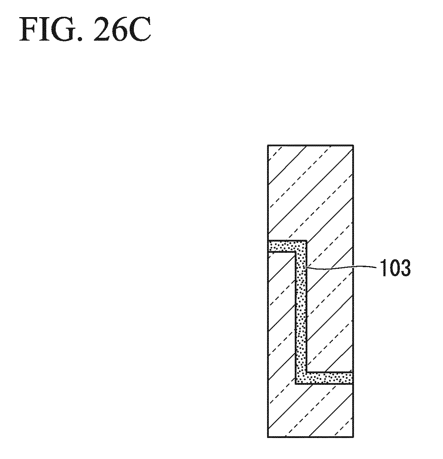

In the conventional method, there is a problem in that when removing the modified regions from the substrate by the wet-etching method, even if the shapes of the modified regions have the same degree of complexity, the degree of ease of etching (etching rate) is different in the individual micro-holes and micro-grooves which are disposed differently in the substrate. For example, in a substrate 101 shown in FIG 26, a first modified region 102 is easily etched, but a second modified region 103 is difficultly etched and the etching time becomes longer. For this reason, there is a problem in that etching of a non-modified region at which the laser is not irradiated progresses excessively before the etching of the second modified region 103 is completed.

The present invention has been made in view of the above problems, and an object of the present invention is to provide a microstructure forming method capable of forming microstructures such as micro-holes at an approximately constant etching rate regardless of a disposition in the substrate, a laser irradiation device used in the microstructure forming method, and a substrate manufactured using the microstructure forming method.

### MEANS FOR SOLVING THE PROBLEMS

According to a first aspect of the present invention, there is provided a microstructure forming method including: a step A of irradiating a region of a substrate, in which a hole-shaped or groove-shaped microstructure is to be formed, with a circularly or elliptically polarized laser beam having a pulse width of which the pulse duration is on the order of picoseconds or shorter, and scanning a focal point at which the laser beam converges to form a modified region; and a step B of performing an etching process on the substrate in which the modified region is formed and removing the modified region to form a microstructure.
According to a second aspect of the present invention, in the microstructure forming method according to the first aspect, in the step A, laser irradiation may be performed while maintaining a direction of an optical axis of the laser beam in a certain direction with respect to a scanning direction of the focal point.
According to a third aspect of the present invention, in the microstructure forming method according to the first or second aspect, the certain direction may be vertical to the scanning direction of the focal point.
According to a fourth aspect of the present invention, in the microstructure forming method according to any one of the first to third aspects, in the step A, the laser beam may be irradiated on only a principal surface side of the substrate.
According to a fifth aspect of the present invention, in the microstructure forming method according to any one of the first to fourth aspects, an inflected portion may be formed in the microstructure.
According to a sixth aspect of the present invention, there is provided a laser irradiation device including: a unit that irradiates a region of a substrate, in which a hole-shaped or groove-shaped microstructure is to be formed, with a circularly or elliptically polarized laser beam having a pulse width of which the pulse duration is on the order of picoseconds or shorter and performs laser irradiation while maintaining a direction of an optical axis of the laser beam in a certain direction with respect to a scanning direction of the focal point when scanning the focal point at which the laser beam converges to form a modified region.
According to a seventh aspect of the present invention, in the laser irradiation device according to the sixth aspect, the unit may be a substrate stage, and the substrate stage may be configured such that according to a change of the scanning direction of the focal point, the direction of the optical axis of the laser beam with respect to the changed scanning direction is in a certain direction.
According to an eighth aspect of the present invention, there is provided a substrate that is manufactured using the microstructure forming method according to any one of the first to fifth aspects.
According to a ninth aspect of the present invention, in the substrate according to the eighth aspect, a flow channel throuch which a fluid passes may be formed in the substrate.

### EFFECTS OF THE INVENTION

According to the microstructure forming method according to the aspect of the present invention, by using a circularly polarized laser beam or an elliptically polarized laser beam as the laser beam, it is possible to suppress an easily etched area and a difficultly etched area from being formed in a banded form in a modified region corresponding to the microstructure. As a result, a large fluctuation does not occur in the ease of etching in the formed modified region (as compared to a case where an area where the ease of etching is different is formed in a banded form as will be described later), and etching can be performed relatively smoothly. Thus, since the microstructure can be formed at such an etching rate with no great fluctuation regardless of the disposition and shape of the modified region in the substrate, it is possible to control the size of the microstructure such as a micro-hole with high accuracy. Since the etching time of the modified regions corresponding to the respective microstructure depends on the length and the depth of the modified regions corresponding to the microstructures, it is possible to calculate the etching time at the step of designing the microstructures, and the production control is made easy.

When laser irradiation is performed while maintaining the direction of the optical axis of the laser beam in a certain direction with respect to the scanning direction of the focal point of the laser beam, it is possible to suppress the easily etched area and the difficultly etched area from being formed in a banded form in the modified region corresponding to the microstructure. Further, the modified region can be modified in an approximately uniform state regardless of the formation position of the modified region in the substrate. That is, the degree of ease of etching can be made substantially uniform in a region (zone) of the entire length of the formed modified region, which is formed by performing laser irradiation while maintaining a certain direction with respect to the scanning direction of the focal point of the laser beam source. Thus, since the microstructure can be formed at an approximately constant etching rate regardless of the disposition and the shape of the modified region in the substrate, it is possible to control the size of the microstructure such as a micro-hole with high accuracy. Since the etching time of the modified regions corresponding to the respective microstructure depends on the length and the depth of the modified regions corresponding to the microstructures, it is possible to calculate the etching time at the step of designing the microstructures, and the production control is made easier.

When performing laser irradiation while maintaining the direction of the optical axis of the laser beam to be vertical to the scanning direction of the focal point of the laser beam, it is possible to suppress the easily etched area and the difficultly etched area from being formed in a banded form in the modified region corresponding to the microstructure and to form a pattern in which both areas are mixed in an indefinite form so as to extend in the scanning direction. That is, the modified region can be formed in approximately the same state regardless of the formation position in the substrate, and a pattern in which the easily etched area and the difficultly etched area are mixed can be formed so as to extend in the scanning direction. By performing laser irradiation while maintaining the direction of the optical axis of the laser beam to be vertical to the scanning direction of the focal point of the laser beam, it is possible to make the degree of ease of etching of the formed modified region approximately constant, and to accelerate the etching rate. This is because when laser irradiation is performed while maintaining the direction of the optical axis of the laser beam to be vertical to the scanning direction of the focal point of the laser beam, the easily etched area tends to be formed quasi-continuously in the modified region along the scanning direction.
Thus, since the microstructure can be formed at an approximately constant etching rate regardless of the disposition and the shape of the modified region in the substrate, it is possible to control the size of the microstructure such as a micro-hole with high accuracy. Moreover, it is possible to shorten the time required for the etching step. Since the etching time of the modified regions corresponding to the respective microstructure depends on the length and the depth of the modified regions corresponding to the microstructures, it is possible to calculate the etching time at the step of designing the microstructures, and the production control is made easy.

When laser irradiation is performed on only the principal surface side of the substrate, it is possible to form the modified region easiler than the case of performing laser irradiation from the side surface of the substrate. That is, since the side surface of the substrate has an extremely smaller area than the principal surface, when performing laser irradiation from the side surface side, it is necessary to irradiate the laser beam approximately vertical to the side surface of the substrate, which is not always easy to do so.
On the other hand, since the principal surface of the substrate has a relatively large area, when laser irradiation is performed on the principal surface side so that the focal point of the laser beam converges at an optional position of the substrate, it is not always necessary to perform laser irradiation in a direction vertical to the principal surface, which is easy to do so.
The principal surface of the substrate is a surface having the largest area among the surfaces that constitute a planar substrate, and in general, the substrate has two opposing principal surfaces. In the aspect of the present invention, the laser irradiation may be performed on only one principal surface (first principal surface) of the two principal surfaces, and the laser irradiation may be performed on both one principal surface (first principal surface) and the other principal surface (second principal surface).

When the inflected portion is formed in the microstructure, it is possible to suppress the easily etched area and the difficultly etched area from being formed in a banded form in a modified region corresponding to the inflected portion and to smoothly form the modified region that extends along the inflected portion. Thus, it is possible to make the degree of ease of etching of the modified region corresponding to the inflected portion approximately the same as the degree of ease of etching of the other modified region corresponding to a straight-line portion. As a result, it is possible to form the microstructure having the inflected portion in a shape with high accuracy.

Moreover, according to the laser irradiation device according to the aspect of the present invention, the laser irradiation device includes the unit that maintains the direction of the optical axis of the circularly polarized laser beam or the elliptically polarized laser beam in a certain direction with respect to the scanning direction of the focal point of the laser beam. Therefore, it is possible to prevent the easily etched area and the difficultly etched area from being formed in a banded form in the modified region which is formed in a desired shape in the substrate. Further, it is possible to modify the modified region in an approximately uniform state regardless of the formation position of the modified region in the substrate. As a result, since the modified region can be removed from the substrate in a wet-etching step performed separately at an approximately constant etching rate regardless of the disposition and the shape of the modified region in the substrate, it is possible to control the size of the formed microstructure such as a micro-hole with high accuracy.

According to the substrate according to the aspect of the present invention, it is possible to provide a substrate having a microstructure which is formed in the substrate in a shape with high accuracy.
When the microstructure is used as a through-hole interconnection, by filling or depositing an electrically conductive substance in the microstructure, it is possible to provide an interconnection substrate that includes an interconnection having a highly accurate shape.
Moreover, when the microstructure is used as a flow channel through which a fluid passes, it is possible to cause various fluids to flow in the micro-hole (flow channel) in accordance with the object. For example, when using the substrate as an interconnection substrate, a coolant such as air or water is circulated in the micro-hole (flow channel). In this case, by the cooling function, it is possible to effectively lower the temperature rise of the substrate even when a device with a large heat value is mounted on the interconnection substrate. In addition, the substrate is used as a substrate that integrates a bio test system using micro-fluidics technology. In this case, it is possible to apply the micro-hole (flow channel) to a flow channel that circulates biopolymer solutions, such as DNA (nucleic acid), protein materials, and lipids.

### BRIEF DESCRIPTION OF THE DRAWINGS

FIG 1A is a plan view showing an example of an interconnection substrate according to the present invention.
FIG 1B is a cross-sectional view taken along the line x-x of FIG 1A.
FIG 1C is a cross-sectional view taken along the line y-y of FIG 1A.
FIG 2A is a plan view showing an example of the interconnection substrate according to the present invention.
FIG 2B is a cross-sectional view taken along the line x-x of FIG 2A.
FIG 2C is a cross-sectional view taken along the line y-y of FIG 2A.
FIG 3A is a plan view showing another example of the interconnection substrate according to the present invention.
FIG 3B is a cross-sectional view taken along the line x1-x1 of FIG 3A.
FIG 3C is a cross-sectional view taken along the line y-y of FIG 3A.
FIG 3D is a cross-sectional view taken along the line x2-x2 of FIG 3A.
FIG 4A is a plan view showing another example of the interconnection substrate according to the present invention.
FIG 4B is a cross-sectional view taken along the line x-x of FIG 4A.
FIG 4C is a cross-sectional view taken along the line y-y of FIG 4A.
FIG 5A is a plan view showing another example of the interconnection substrate according to the present invention.
FIG 5B is a cross-sectional view taken along the line x-x of FIG 5A.
FIG 5C is a cross-sectional view taken along the line y-y of FIG 5A.
FIG 6A is a plan view showing a substrate used in an example of a microstructure forming method according to the present invention.
FIG 6B is a cross-sectional view taken along the line x-x of FIG 6A.
FIG 6C is a cross-sectional view taken along the line y-y of FIG 6A.
FIG 7 is a diagram illustrating the angle between a laser beam used in the present invention and the direction of scanning a focal point of the laser beam.
FIG 8 is a cross-sectional view of a substrate used in an example of a microstructure forming method according to the present invention.
FIG 9 is a cross-sectional view of a substrate used in an example of the microstructure forming method according to the present invention.
FIG 10 is a cross-sectional view of a substrate used in another example of the microstructure forming method according to the present invention.
FIG 11A is a plan view of a substrate used in an example of the microstructure forming method according to the present invention.
FIG 11B is a cross-sectional view taken along the line x-x of FIG 11A.
FIG 11C is a cross-sectional view taken along the line y-y of FIG 11A.
FIG 12A is a plan view showing a substrate used in an example of the microstructure forming method according to the present invention.
FIG 12B is a cross-sectional view taken along the line x-x of FIG 12A.
FIG 12C is a cross-sectional view taken along the line y-y of FIG 12A.
FIG 13A is a plan view showing a substrate used in another example of the microstructure forming method according to the present invention.
FIG 13B is a cross-sectional view taken along the line x-x of FIG 13A.
FIG 13C is a cross-sectional view taken along the line y-y of FIG 13A.
FIG 14A is a plan view showing a substrate used in another example of the microstructure forming method according to the present invention.
FIG 14B is a cross-sectional view taken along the line x-x of FIG 14A.
FIG 14C is a cross-sectional view taken along the line y-y of FIG 14A.
FIG 15A is a plan view showing a substrate used in another example of the microstructure forming method according to the present invention.
FIG 15B is a cross-sectional view taken along the line x-x of FIG 15A.
FIG 15C is a cross-sectional view taken along the line y-y of FIG 15A.
FIG 16 is a schematic configuration diagram of an example of a laser irradiation device according to the present invention.
FIG 17 is a flowchart showing an example of an interconnection substrate forming method using the laser irradiation device according to the present invention.
FIG 18A is a plan view of a substrate.
FIG 18B is a cross-sectional view taken along the line x-x of FIG 18A.
FIG 18C is a cross-sectional view taken along the line y1-y1 of FIG 18A.
FIG 18D is a cross-sectional view taken along the line y2-y2 of FIG 18A.
FIG 19A is a plan view of a substrate.
FIG 19B is a cross-sectional view taken along the line x-x of FIG 19A.
FIG 19C is a cross-sectional view taken along the line y1-y1 of FIG 19A.
FIG 19D is a cross-sectional view taken along the line y2-y2 of FIG 19A.
FIG 20A is an enlarged view of a region F1 of FIG 19C.
FIG 20B is an enlarged view of of a region F2 of FIG 19D.
FIG 21 is a plan view of a substrate illustrating a microstructure forming method.
FIG 22A is a plan view of a substrate.
FIG 22B is a cross-sectional view taken along the line y1-y1 of FIG 22A.
FIG 22C is a cross-sectional view taken along the line y2-y2 of FIG 22A.
FIG 23 is a view in which Part (a) is a plan view of the substrate, and Parts (b) and (c) are enlarged views.
FIG 24A is a view in which Part (a) is a cross-sectional view taken along the line y1-y1 of Part (a) of FIG 23, and Part (b) is an enlarged view.
FIG 24B is a view in which Part (a) is a cross-sectional view taken along the line y2-y2 of Part (a) of FIG 23, and Part (b) is an enlarged view.
FIG 25A is a plan view of a substrate.
FIG 25B is a cross-sectional view taken along the line y1-y1 of FIG 25A.
FIG 25C is a cross-sectional view taken along the line y2-y2 of FIG 25A.
FIG 26A is an example of a conventional substrate in which a micro-hole which is a microstructure is formed.
FIG 26B is a cross-sectional view taken along the line x-x of FIG 26A.
FIG 26C is a cross-sectional view taken along the line y-y of FIG 26A.

### EMBODIMENTS FOR CARRYING OUT THE INVENTION

Hereinbelow, embodiments of the present invention will be described with reference to the drawings. In the following description, although a case of forming a microstructure in a substrate and using the microstructure as through-hole interconnections or flow channels is described by way of an example, the use of microstructures formed in a substrate in the present invention is not limited thereto.

### <First Embodiment: Interposer Substrate 10>

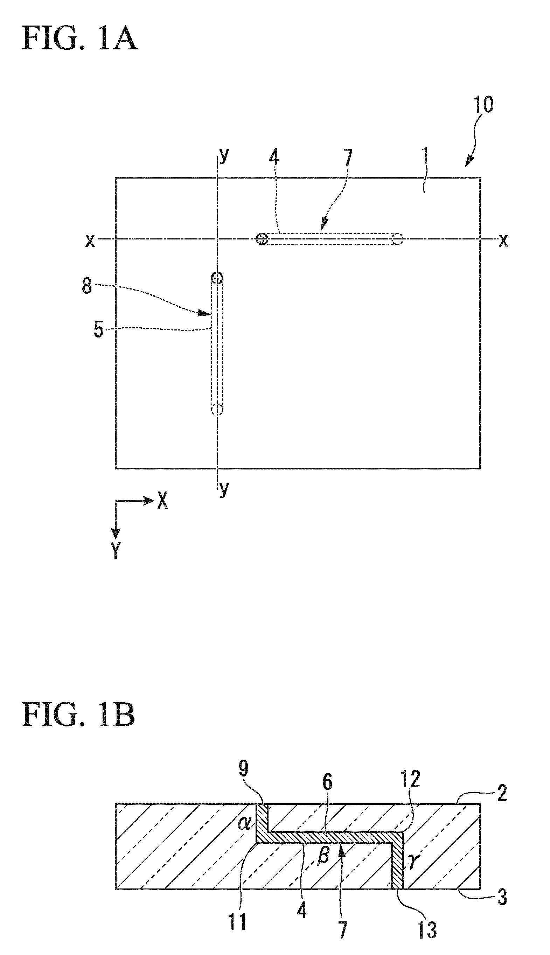

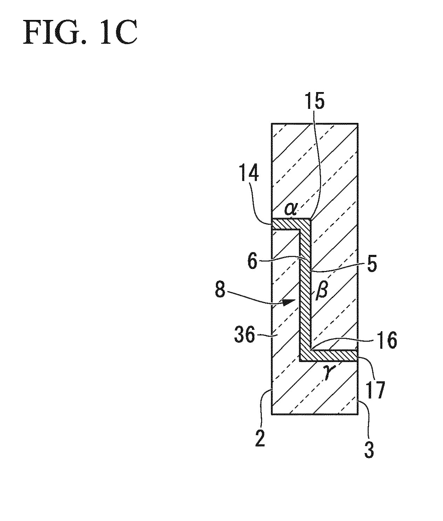

FIGS. 1A, 1B, and 1C show an interposer substrate 10 which is an example of an interconnection substrate which can be manufactured according to a microstructure forming method according to an embodiment of the present invention. FIG 1A is a plan view of the interposer substrate 10, and FIGS. 1B and 1C are cross-sectional views of the interposer substrate 10. FIG 1B shows a cross-section taken along the line x-x of FIG 1A, and FIG 1C shows a cross-section taken along the line y-y of FIG 1A.
The interposer substrate 10 includes a first through-hole interconnection 7 and a second through-hole interconnection 8. A first micro-hole 4 and a second micro-hole 5 are formed in a substrate 1 so as to connect a first principal surface (one principal surface) 2 of the substrate 1 and a second principal surface (the other principal surface) 3. The first through-hole interconnection 7 and the second through-hole interconnection 8 are formed by filling or depositing an electrically conductive substance 6 in the first and second micro-holes.

The first through-hole interconnection 7 includes a region α that extends from an opening portion 9 that appears on the first principal surface 2 to a first bent portion 11 in the thickness direction of the substrate 1, a region β that extends from the first bent portion 11 to a second bent portion 12 in parallel with the principal surface of the substrate 1 and in a lateral direction (X-direction) of the substrate 1, and a region γ that extends from the second bent portion 12 to an opening portion 13 that appears on the second principal surface 3 in the thickness direction of the substrate 1.
A region α, a region β, and a region γ of the first micro-hole 4 correspond to the region α, the region β, and the region γ of the first through-hole interconnection 7, respectively.

The second through-hole interconnection 8 includes a region α that extends from an opening portion 14 that appears on the first principal surface 2 to a first bent portion 15 in the thickness direction of the substrate 1, a region β that extends from the first bent portion 15 to a second bent portion 16 in parallel with the substrate 1 and in the longitudinal direction (Y-direction) of the substrate 1, and a region γ that extends from the second bent portion 16 to an opening portion 17 that appears on the second principal surface 3 in the thickness direction of the substrate 1.
A region α, a region β, and a region γ of the second micro-hole 5 correspond to the region α, the region β, and the region γ of the second through-hole interconnection 8, respectively.

### <Second Embodiment: Interposer Substrate 210>

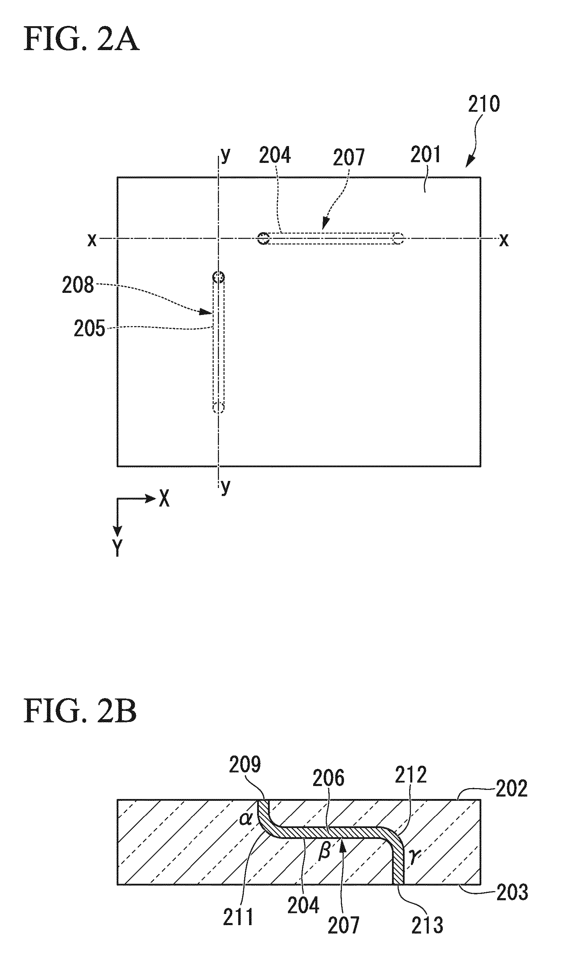

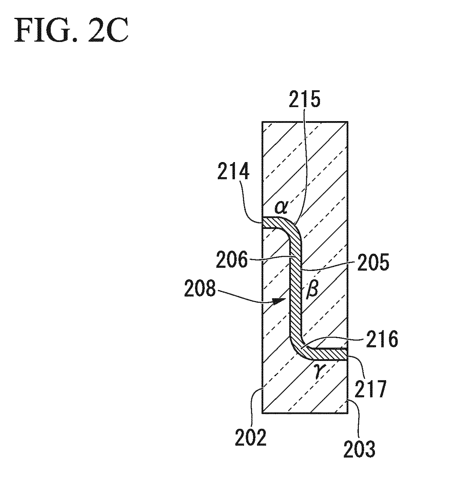

FIGS. 2A, 2B, and 2C show an interposer substrate 210 which is another example of an interconnection substrate which can be manufactured according to a microstructure forming method according to an embodiment of the present invention. FIG 2A is a plan view of the interposer substrate 210. FIGS. 2B and 2C are cross-sectional views of the interposer substrate 210. FIG 2B shows a cross-section taken along the line x-x of FIG 2A, and FIG 2C shows a cross-section taken along the line y-y of FIG 2A.
The interposer substrate 210 includes a first through-hole interconnection 207 and a second through-hole interconnection 208. A first micro-hole 204 and a second micro-hole 205 are formed in a substrate 201 so as to connect a first principal surface (one principal surface) 202 of the substrate 201 and a second principal surface (the other principal surface) 203. The first through-hole interconnection 207 and the second through-hole interconnection 208 are formed by filling or depositing an electrically conductive substance 206 in the first and second micro-holes.

The first through-hole interconnection 207 includes a region α (straight-line portion α) that extends from an opening portion 209 that appears on the first principal surface 202 to a first inflected portion 211 in the thickness direction of the substrate 201, a region β (straight-line portion β) that extends from the first inflected portion 211 to a second inflected portion 212 in parallel with the two principal surfaces of the substrate 201 and in the lateral direction (X-direction) of the substrate 201, and a region γ (straight-line portion γ) that extends from the second inflected portion 212 to an opening portion 213 that appears on the second principal surface 203 in the thickness direction of the substrate 201.
A region α, a region β, and a region γ of the first micro-hole 204 correspond to the region α, the region β, and the region γ of the first through-hole interconnection 207, respectively.

On a longitudinal cross-section taken along the center line of the first through-hole interconnection 207, the first inflected portion 211 and the second inflected portion 212 have a circular arc shape. In the first inflected portion 211 and the second inflected portion 212 according to the present embodiment, the radius of curvature R of a circular arc drawn by the center line is set to 70 µm, the diameter of the first through-hole interconnection 207 is set to 40 µm, and the thickness of the substrate 201 is set to 300 µm.

Although the radius of curvature R depends on the diameter of the first through-hole interconnection 207 and the thickness of the substrate 201, the radius of curvature R is preferably in the range of 10 to 1000 µm. With that range of radii of curvature, it is possible to connect the region α to the region β and the region β to the region γ more smoothly via the first and second inflected portions 211 and 212, respectively.

Since the first through-hole interconnection 207 includes the inflected portion instead of the bent portion, it is possible to decrease transmission loss of electrical signals such as high-frequency signals and to suppress a conduction error caused by the separation of the electrically conductive substance 206 from the first micro-hole 204.

The second through-hole interconnection 208 includes a region α (straight-line portion α) that extends from an opening portion 214 that appears on the first principal surface 202 to a first inflected portion 215 in the thickness direction of the substrate 201, a region β (straight-line portion β) that extends from the first inflected portion 215 to a second inflected portion 216 in parallel with the principal surface of the substrate 201 and in the longitudinal direction (Y-direction) of the substrate 1, and a region γ (straight-line portion γ) that extends from the second inflected portion 216 to an opening portion 217 that appears on the second principal surface 203 in the thickness direction of the substrate 201.
A region α, a region β, and a region γ of the first micro-hole 205 correspond to the region α, the region β, and the region γ of the first through-hole interconnection 208, respectively.

On a longitudinal cross-section taken along the center line of the second through-hole interconnection 208, the first inflected portion 214 and the second inflected portion 215 have a circular arc shape. In the first inflected portion 215 and the second inflected portion 216 according to the present embodiment, the radius of curvature R of a circular arc drawn by the center line is set to 70 µm, the diameter of the second through-hole interconnection 208 is set to 40 µm, and the thickness of the substrate 201 is set to 300 µm.

Although the radius of curvature R depends on the diameter of the second through-hole interconnection 208 and the thickness of the substrate 201, the radius of curvature R is preferably in the range of 10 to 1000 µm. With that range of radii of curvature, it is possible to connect the region α to the region β and the region β to the region γ more smoothly via the first and second inflected portions 215 and 216, respectively.

Since the second through-hole interconnection 208 includes the inflected portion instead of the bent portion, it is possible to decrease transmission loss of electrical signals such as high-frequency signals and to suppress a conduction error caused by the separation of the electrically conductive substance 206 from the first micro-hole 205.

### <Third Embodiment: Interposer Substrate 310>

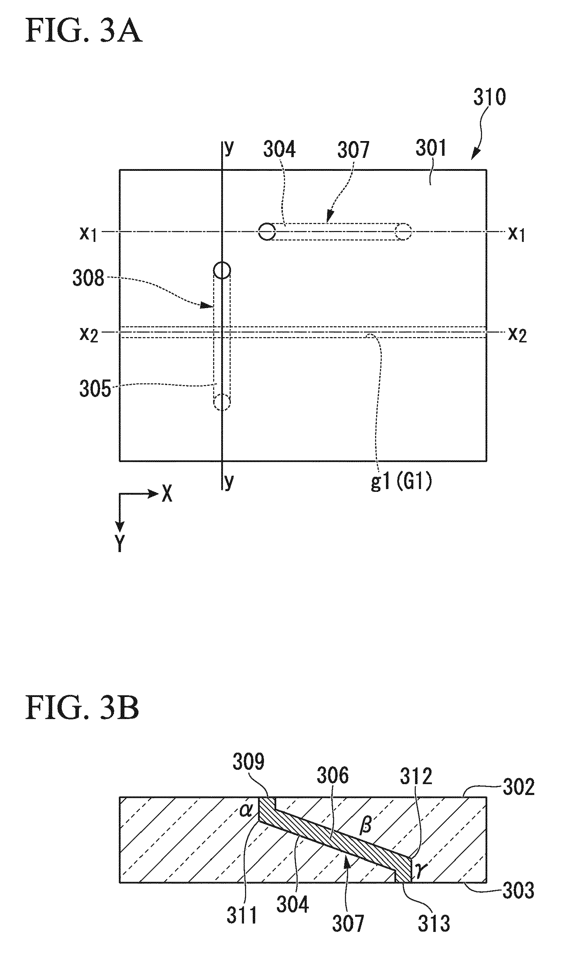

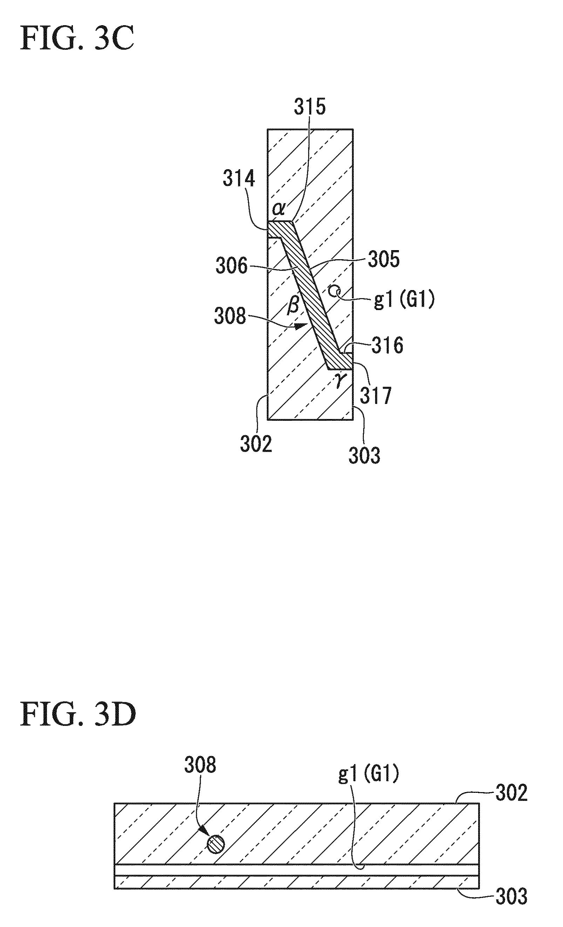

FIGS. 3A, 3B, 3C, and 3D show an interposer substrate 310 which is another example of an interconnection substrate which can be manufactured according to a microstructure forming method according to an embodiment of the present invention. FIG 3A is a plan view of the interposer substrate 310, and FIGS. 3B, 3C, and 3D are cross-sectional views. FIG 3B shows a cross-section taken along the line x1-x1 of FIG 3A, FIG 3C shows a cross-section taken along the line y-y of FIG 3A, and FIG 3D shows a cross-section taken along the line x2-x2 of FIG 3A.
The interposer substrate 310 includes a first through-hole interconnection 307 and a second through-hole interconnection 308 that are formed by filling or depositing an electrically conductive substance 306 in a first micro-hole 304 and a second micro-hole 305 which are disposed so as to connect a first principal surface (one principal surface) 302 of a substrate 301 and a second principal surface (the other principal surface) 303. Moreover, a first flow channel G1 formed from a first micro-hole g1 is formed.

The first through-hole interconnection 307 includes a region α that extends from an opening portion 309 that appears on the first principal surface 302 to a first bent portion 311 in the thickness direction of the substrate 301, a region β that extends from the first bent portion 311 to a second bent portion 312 with an inclination non-parallel with the principal surface of the substrate 301 and in the lateral direction (X-direction) of the substrate 301, and a region γ that extends from the second bent portion 312 to an opening portion 313 that appears on the second principal surface 303 in the thickness direction of the substrate 301.
A region α, a region β, and a region γ of the first micro-hole 304 correspond to the region α, the region β, the region γ of the first through-hole interconnection 307, respectively.

The second through-hole interconnection 308 includes a region α that extends from an opening portion 314 that appears on the first principal surface 302 to a first bent portion 315 in the thickness direction of the substrate 301, a region β that extends from the bent portion 315 to a second bent portion 316 with an inclination non-parallel with the principal surface of the substrate 301 and in the longitudinal direction (Y-direction) of the substrate 301, and a region γ that extends from the second bent portion 316 to an opening portion 317 that appears on the second principal surface 303 in the thickness direction of the substrate 301.
A region α, a region β, and a region γ of the second micro-hole 305 correspond to the region α, the region β, the region γ of the second through-hole interconnection 308, respectively.

The first flow channel G1 formed of the first micro-hole g1 is provided to extend in the lateral direction (X-direction) of the substrate 301 along both principal surfaces of the substrate 301. The first micro-hole g1 has openings on the two opposing side surfaces of the substrate 1, through which a refrigerant enters and exits.
Although not shown in FIGS. 1A to 2C, the same flow channel formed of the micro-hole may be formed in the interposer substrates 10 and 210 described above.

### <Fourth Embodiment: Surface Interconnection Substrate 30>

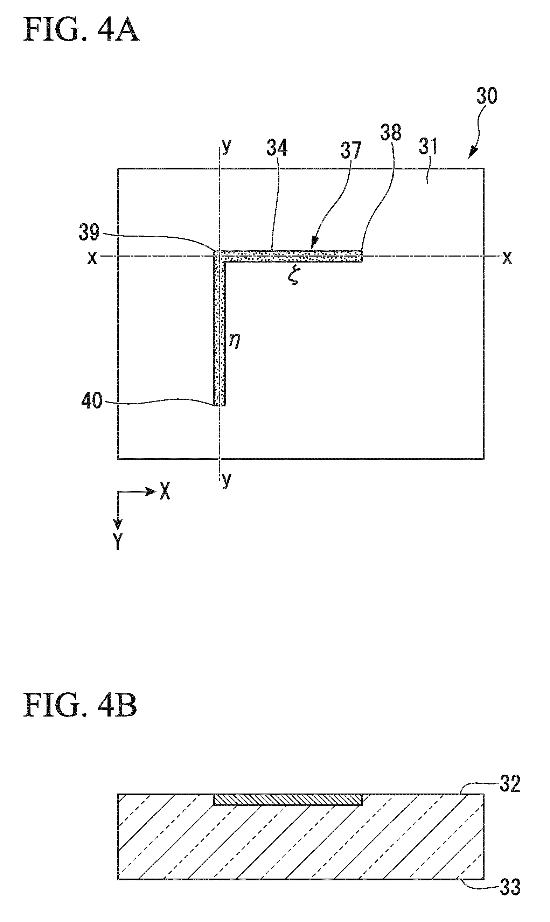

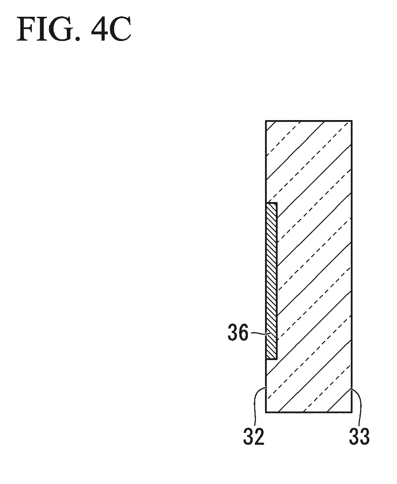

FIGS. 4A, 4B, and 4C show a surface interconnection substrate 30 which is another example of the interconnection substrate that can be manufactured according to the microstructure forming method according to an embodiment of the present invention. FIG 4A is a plan view of the surface interconnection substrate 30, and FIGS. 4B and 4C are cross-sectional views. FIG 4B shows a cross-section taken along the line x-x of FIG 4A, and FIG 4C shows a cross-section taken along the line y-y of FIG 4A.
The surface interconnection substrate 30 includes a first surface interconnection 37 that is formed by filling or depositing an electrically conductive substance 36 in a first micro-groove 34 that is formed in the surface of a first principal surface (one principal surface) 32 of a substrate 31.

The first surface interconnection 37 includes a region ζ that extends from a first end portion (one end portion) 38 to a first bent portion 39 in the lateral direction (X-direction) of the substrate 31 and a region η that extends from the first bent portion 39 to a second end portion (the other end portion) 40 in the longitudinal direction (Y-direction) of the substrate 31.
The region ζ and the region η of the first surface interconnection 37, the first end portion 38, the first bent portion 39, and the second end portion 40 correspond to a region ζ and a region η of the first micro-groove 34, a first end portion 38, and a second end portion 40.

### <Fifth Embodiment: Surface Interconnection Substrate 230>

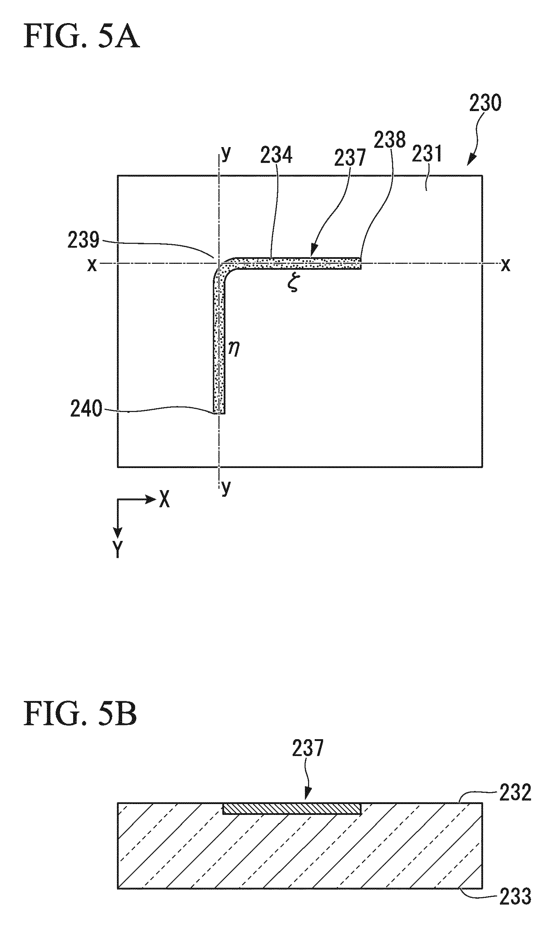

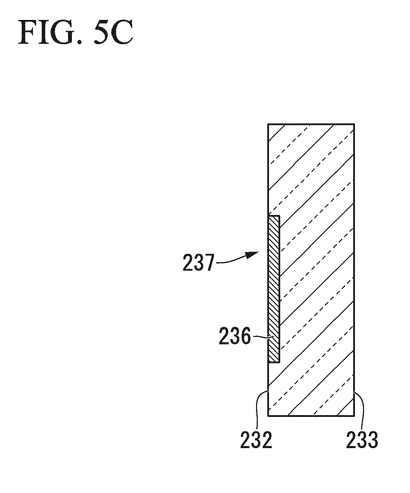

FIGS. 5A, 5B, and 5C show a surface interconnection substrate 230 which is another example of the interconnection substrate that can be manufactured according to the microstructure forming method according to an embodiment of the present invention. FIG 5A is a plan view of the surface interconnection substrate 230, and FIGS. 5B and 5C are cross-sectional views. FIG 5B shows a cross-section taken along the line x-x of FIG 5A, and FIG 5C shows a cross-section taken along the line y-y of FIG 5A.
The surface interconnection substrate 230 includes a first surface interconnection 237 that is formed by filling or depositing an electrically conductive substance 236 in a micro-groove 234 that is formed in the surface of a first principal surface (one principal surface) 232 of a substrate 231.

The first surface interconnection 237 includes a region (straight-line portion ζ) that extends from a first end portion (one end portion) 238 to a first inflected portion 239 in the lateral direction (X-direction) of the substrate 231 and a region η (straight-line portion η) that extends from the first inflected portion 239 to a second end portion (the other end portion) 240 in the longitudinal direction (Y-direction) of the substrate 231.
A region ζ and a region η of the first micro-groove 234, a first end portion 238, and a second end portion 240 correspond to the region ζ and the region η of the first surface interconnection 237, the first end portion 238, the first inflected portion 239, and the second end portion 240.

When the first surface interconnection 237 is seen from the thickness direction, the first inflected portion 239 has a circular arc shape. In this example, the radius of curvature R of a circular arc drawn by the inflected portion 239 is 70 µm, and the diameter of the first surface interconnection 237 is 40 µm.
Although the radius of curvature R depends on the diameter of the first through-hole interconnection 237, the radius of curvature R is preferably in the range of 10 to 1000 µm. With that range of radii of curvature, it is possible to connect the region ζ to the region η more smoothly via the first inflected portion 239.
Since the first surface interconnection 237 includes the inflected portion instead of the bent portion, it is possible to decrease transmission loss of electrical signals such as high-frequency signals and to suppress a conduction error caused by the separation of the electrically conductive substance 236 from the first micro-groove 234.

Examples of the material of the substrates 1, 201, 31, and 231 of the interposer substrates 10, 210, and 310 and the surface interconnection substrates 30 and 230 include an insulator such as glass or sapphire and a semiconductor such as silicon (Si). Since these materials have a linear expansion coefficient that is close to that of a semiconductor device, the interposer substrate or the surface interconnection substrate can be connected to the semiconductor device using solder or the like with no positional shift and high accuracy. Among these materials, an insulating glass is preferred. When glass is used as the material of the substrate, it is possible to obtain an advantage that it is not necessary to form an insulating layer on the inner wall surfaces of the micro-hole and the micro-groove, and there is no inhibiting factor of high-speed transmission such as the presence of a stray capacitance component.

The thicknesses (the distance from the first principal surfaces 2, 202, 302, 32, and 232 to the second principal surfaces 3, 203, 303, 33, and 233) of the substrates 1, 201, 301, 31, and 231 can be appropriately set, for example, in the range of approximately 150 µm to 1 mm.
Examples of the electrically conductive substances 6, 206, 36, 236, and 306 that are filled or deposited in the respective micro-holes 7, 8, 207, 208, 307, and 308 and the first micro-grooves 37 and 237 disposed in the interposer substrates 10, 210, and 310 and the surface interconnection substrates 30 and 230 include gold-tin (Au-Sn) and copper (Cu).

The shape of the microstructure formed in the interconnection substrate according to the embodiment of the present invention, and the patterns and cross-sectional shapes of the through-hole interconnection, the surface interconnection, and the flow channel are not limited to the above examples and may be designed appropriately.

### <Method of Manufacturing Interposer Substrate 10>

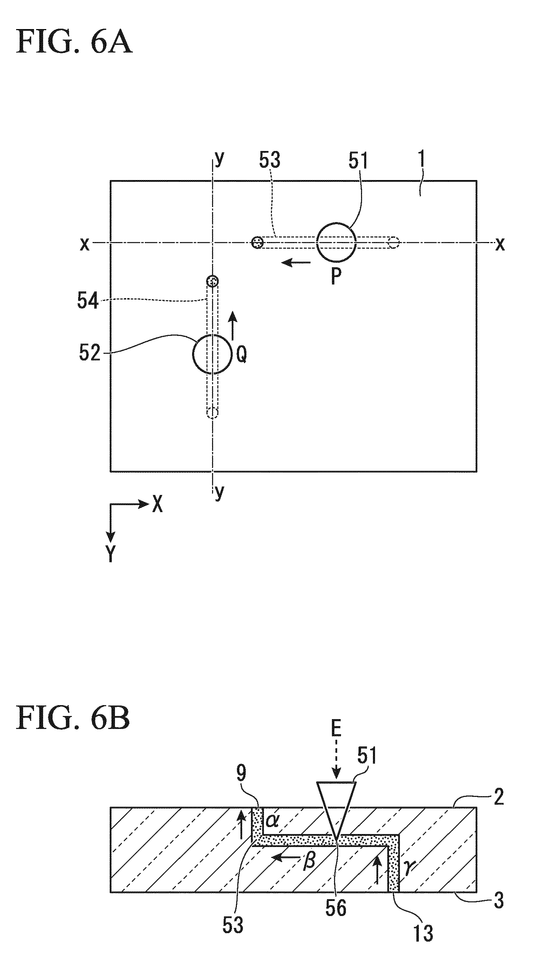

Next, a method of manufacturing the interposer substrate 10 is shown in FIGS. 6A to 15C as an example of a method of forming a micro-hole and a micro-groove in the interconnection substrate of the present invention.
Here, FIGS. 6A to 6C and FIGS. 11A to 15C are plan views and cross-sectional views of the substrate 1 used for manufacturing the interposer substrate 10. FIGS. 6A, 11A, 12A, 13A, 14A, and 15A are plan views of the substrate 1, FIGS. 6B, 6C, 11B, 11C, 12B, 12C, 13B, 13C, 14B, 14C, 15B, and 15C are cross-sectional views of the substrate 1 taken along the lines x-x and y-y of the respective plan views.

### [Step A]

First, as shown in FIGS. 6A to 6C, the substrate 1 is irradiated with a first laser beam 51 and a second laser beam 52 to form a first modified region 53 and a second modified region 54, in which the material of the substrate 1 is modified, in the substrate 1. The respective modified regions are respectively formed in regions where the first through-hole interconnection 7 and the second through-hole interconnection 8 are formed. The first laser beam 51 and the second laser beam 52 may be circularly polarized beams or elliptically polarized beams.

Examples of the material of the substrate 1 include an insulator such as glass or sapphire and a semiconductor such as silicon (Si). Since these materials have a linear expansion coefficient that is close to that of a semiconductor device, the interposer substrate or the surface interconnection substrate can be connected to the semiconductor device using solder or the like with no positional shift and high accuracy. Among these materials, an insulating glass is preferred. When glass is used as the material of the substrate, it is possible to obtain an advantage that it is not necessary to form an insulating layer on the inner wall surfaces of the micro-hole and the micro-groove, and there is no inhibiting factor of high-speed transmission such as the presence of a stray capacitance component.
The thickness of the substrate 1 can be appropriately set, for example, in the range of approximately 150 µm to 1 mm.

The first laser beam 51 and the second laser beam 52 are irradiated on the first principal surface (one principal surface) 2 side of the substrate 1, and a first focal point 56 and a second focal point 57 converge at a desired position within the substrate 1. The material of the substrate 1 is modified at the converging position of the respective focal points 56 and 57.
Thus, the positions of the first focal point 56 and the second focal point 57 are sequentially shifted and scanned (moved) while irradiating the first laser beam 51 and the second laser beam 52 so that the respective focal points 56 and 57 converge over the entire region where the first micro-hole 4 and the second micro-groove 5 are formed. In this way, it is possible to form the first modified region 53 and the second modified region 54.

The respective laser beams 51 and 52 may be irradiated on the first principal surface 2 side and/or the second principal surface (the other principal surface) 3 side of the substrate 1 and may be irradiated on the side surfaces of the substrate 1. It is preferable to irradiate the laser beam from only both the principal surfaces 2 and 3 side because it is easier to do so. The angle between the optical axis E of each of the incident laser beams 51 and 52 and the substrate 1 is set to a predetermined angle. The respective laser beams 51 and 52 may be irradiated sequentially using a single laser beam and may be irradiatedly simultaneously using a plurality of laser beams.

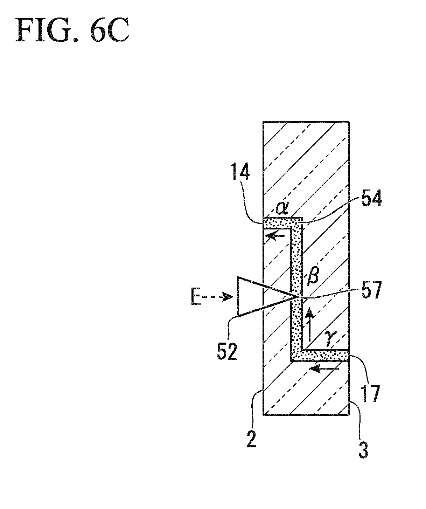

Moreover, the example of the direction of scanning the focal points 56 and 57 of the respective laser beams 51 and 52 includes a single-stroke direction where the focal points are scanned in the order of the region γ, the region β, and the region α as indicated by an arrow depicted by a solid line that extends along the respective modified regions 53 and 54 shown in FIGS. 6B and 6C. That is, the arrow indicates that the focal points 56 and 57 are scanned from the position corresponding to the opening portions 13 and 17 of the second principal surface 3 of the substrate 1 to the position corresponding to the opening portions 9 and 14 of the first principal surface 2. In this case, it is preferable to perform one-stroke scanning in the direction indicated by the arrow from the perspective of manufacturing efficiency.

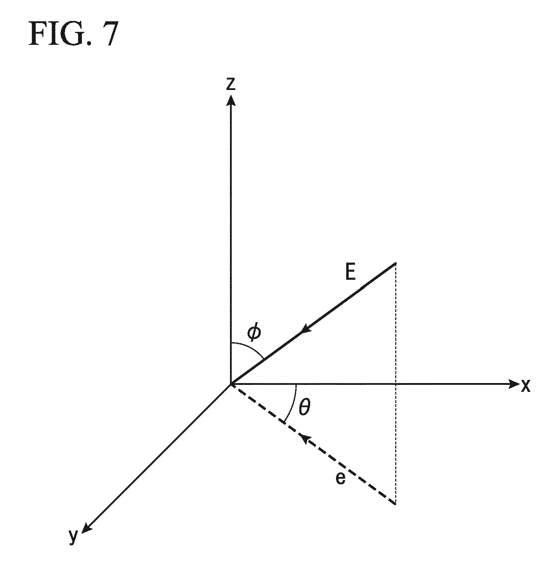

The angle between the optical axis E of the laser beam and the focal point scanning direction (the extension direction of the modified region) can be defined using angles θ and ϕ as shown in FIG 7. That is, in an orthogonal coordinate system of the three axes xyz of FIG 7, when the positive direction of the x-axis is the focal point scanning direction, the optical axis E (indicated by arrow E) of the laser beam is defined by the angle θ with respect to the positive direction of the x-axis and the angle ϕ with respect to the positive direction of the z-axis. In FIG 7, an arrow e indicates a projection of the optical axis E (the laser beam scanning direction) on the x-y plane.

In FIG 6B, the direction of the optical axis E of the first laser beam 51 is vertical to the scanning direction (the extension direction of the region β of the first modified region 53) of the first focal point 56, and the angles θ and ϕ are 0°.
Similarly, in FIG 6C, the direction of the optical axis E of the second laser beam 52 is vertical to the scanning direction (the extension direction of the region β of the second modified region 54) of the second focal point 57, and the angles θ and ϕ are 0°.

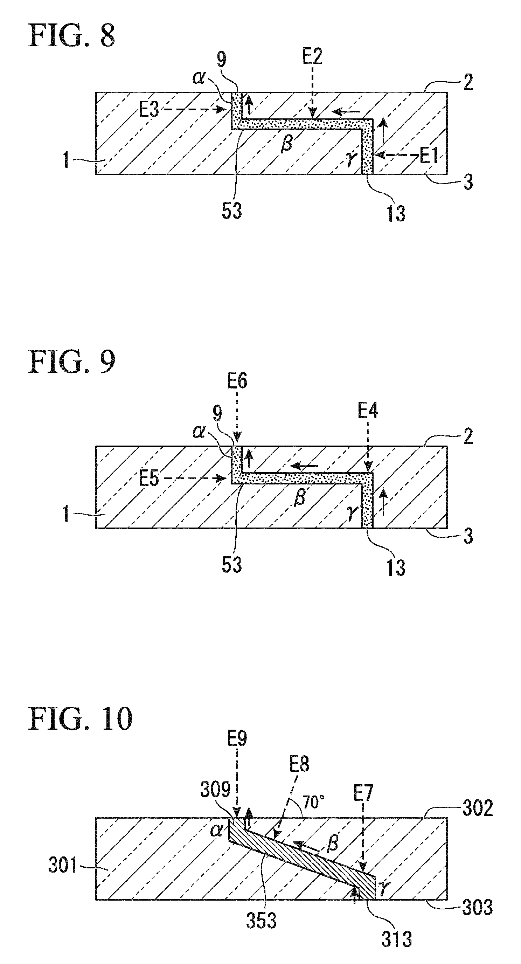

When forming the first modified region 53, it is preferable to irradiate the regions α to γ with a laser beam while maintaining the direction of the optical axis E of the first laser beam 51 in a certain direction with respect to the scanning direction of the first focal point 56 (FIG 8).
Here, "maintaining the direction of the optical axis of the laser beam in a certain direction with respect to the scanning direction of the focal point" means maintaining the relative positional relationship between the direction of the optical axis E and the scanning direction of the focal point to be constant and means fixing the angles θ and ϕ to optional specific angles.

As shown in FIG 8, when scanning is performed in the order of the region γ, the region β, and the region α to form the first modified region 53 while maintaining the direction of the optical axis E of the first laser beam 51 to be vertical to the scanning direction of the first focal point 56, the directions of the optical axis E in the respective regions are represented by arrows E1, E2, and E3 indicated by broken lines. Here, FIG 8 shows the same cross-section as that of FIG 6B, and the arrows indicated by the solid lines that extend in the extension directions of the respective regions α to γ indicate the scanning direction of the first focal point 56.

In FIG 8, the first laser beam 51 is irradiated in a direction vertical to the side surface of the substrate 1 when forming the regions α and γ, and the first laser beam 51 is irradiated in a direction vertical to the first principal surface 2 of the substrate 1 when forming the region β.

By irradiating the light beam while maintaining the direction of the optical axis of the laser beam in a certain direction (in this example, a vertical direction) to the scanning direction of the focal point in this way, it is possible to suppress an easily etched area and a difficultly etched area from being formed in a banded form in the regions α to γ of the formed first modified region 53 and to form a pattern in which both areas are mixed in an indefinite form so as to extend in the scanning direction. More specifically, the easily etched areas are formed quasi-continuously along the scanning direction in the regions α to γ of the modified region in a spiral form of which the center corresponds to the optical axis of the laser beam. Since the easily etched areas are preferentially etched in a subsequent etching step so that an etching solution can easily penetrate in the extension direction of the modified region, it is possible to accelerate the etching rate of the modified region.
Moreover, since the modified state of the regions α to γ of the modified region can be made uniform, the etching rate of the regions α to γ can be made uniform in the subsequent etching step.

Moreover, by setting the angles θ and ϕ of the first laser beam 51 to be the same as the angles θ and ϕ of the second laser beam 52, the modified state of the first modified region 53 and the modified state of the second modified region 54 can be made uniform. As a result, the etching rate of the first modified region 53 in the subsequent etching step can be made approximately the same as the etching rate of the second modified region 54, and the first micro-hole 4 and the second micro-hole 5 can be formed in a shape with high accuracy.

The angles θ and ϕ of the respective laser beams 51 and 52 are not limited to 0°, and the angles θ and ϕ can be independently set to an optional angle.
For example, a combination (θ, ϕ) of the angles θ and ϕ is set to (0°, 90°), the direction of the optical axis E of the laser beam is parallel to the scanning direction (the extension direction of the modified region) of the focal point.

As shown in FIG 9, when scanning is performed in the order of the region γ, the region β, and the region α to form the first modified region 53 while maintaining the direction of the optical axis E of the first laser beam 51 in parallel to the scanning direction of the first focal point 56, the directions of the optical axis E in the respective regions are represented by arrows E4, E5, and E6 indicated by broken lines. Here, FIG 9 shows the same cross-section as that of FIG 6B, and the arrows indicated by the solid lines that extend in the extension direction of the respective regions α to γ indicate the scanning direction of the first focal point 56.

In FIG 9, the first laser beam 51 is irradiated in a direction vertical to the first principal surface 2 of the substrate 1 when forming the regions α and γ, and the first laser beam 51 is irradiated in a direction vertical to the side surface of the substrate 1 when forming the region β.

By irradiating the laser beam while maintaining the direction of the optical axis of the laser beam in parallel to the scanning direction of the focal point in this way, it is possible to suppress the easily etched area and the difficultly etched area from being formed in a banded form in the regions α to γ of the formed first modified region 53.
Moreover, since the modified state of the regions α to γ of the modified region can be made uniform, the etching rate of the regions α to γ in the subsequent etching step can be made uniform.

In the microstructure forming method according to the embodiment of the present invention, the laser beam may be irradiated while maintaining the direction of the optical axis of the laser beam in a certain direction with respect to the scanning direction of the focal point, and the laser beam may be irradiated without maintaining the direction of the optical axis in a certain direction.
When the laser beam is irradiated while maintaining the direction of the optical axis of the laser beam in a certain direction with respect to the scanning direction of the focal point when scanning the entire region corresponding to the modified region, as described above, the modified state can be made uniform over the entire region of the modified region.

On the other hand, even when the laser beam is irradiated without maintaining the direction of the optical axis in a certain direction, the modified state does not change extremely over the entire region of the modified region but remains approximately at the same state although it cannot be said to be uniform. Thus, an extremely large fluctuation does not occur in the etching rate in the subsequent etching step. This is because in the embodiment of the present invention, a circularly polarized laser beam or an elliptically polarized laser beam is used, the easily etched area and the difficultly etched area are suppressed from being alternately formed in a banded form as seen from the extension direction of the modified region, which is observed in a modified region that is formed using a linear polarized laser beam.
The "extremely large fluctuation of the etching rate" means a fluctuation of the etching rate in the modified region in which the easily etched area and the difficultly etched area are alternately formed, which is formed when a linear polarized laser beam is ued. The state of the modified region when a linear polarized laser beam is used will be described later.

The laser beam used in the microstructure forming method according to the embodiment of the present invention is a circularly polarized beam or an elliptically polarized beam. The circularly polarized beam may be a right circularly polarized beam or a left circularly polarized beam. The elliptically polarized beam may be a right elliptically polarized beam or a left elliptically polarized beam. The elliptically polarized beam is preferably an elliptically polarized beam that is close to a circularly polarized beam in order to achieve a sufficient advantage according to the embodiment of the present invention.
Such a circularly polarized laser beam or such an elliptically polarized laser beam can be obtained, for example, by passing a femtosecond laser beam through an existing appropriate phase retarder.

By scanning the focal points 56 and 57 of the circularly polarized laser beams or elliptically polarized laser beams 51 and 52 on the regions corresponding to the modified regions 53 and 54, it is possible to form the modified regions 53 and 54 having a diameter of several µm to several tens of µm, for example. Moreover, by controlling the converging position of the focal points 56 and 57, it is possible to form the modified regions 53 and 54 having a desired shape.

The modified region corresponding to the first micro-hole 204 of the interposer substrate 210 can be formed in a manner similarly to the modified region 53 corresponding to the first micro-hole 4 of the interposer substrate 10.
By forming the modified regions corresponding to the inflected portions of the through-hole interconnections 207 and 208 of the interposer substrate 210 using irradiation of a circularly polarized laser beam or an elliptically polarized laser beam, it is possible to suppress the easily etched area and the difficultly etched area from being formed in a banded form in the modified region corresponding to the inflected portion and to smoothly form the modified region so as to correspond to the shape of the inflected portion. Thus, the degree of ease of etching of the modified region corresponding to the inflected portion can be made to be approximately the same as the degree of ease of etching of the other modified regions corresponding to the straight-line portions. As a result, it is possible to form the microstructure having the inflected portion in a shape with high accuracy.

The modified regions corresponding to the first micro-hole 304 and the second micro-hole 305 of the interposer substrate 310 can be formed in a manner similarly to the modified region corresponding to the micro-hole of the interposer substrate 10.
Moreover, when forming the modified region corresponding to the first micro-hole 304, a method of irradiating the circularly polarized laser beam or the elliptically polarized laser beam from only the first principal surface 302 side of the substrate 301 may be used. That is, the following method may be used.

FIG 10 shows the same cross-section as that of FIG 3B, and arrows indicated by solid lines that extend in the extension directions of the respective regions α to γ represent the scanning direction of the focal point of the laser beam.
As shown in FIG 10, when forming the regions α and γ of the modified region corresponding to the first micro-hole 304, the directions E9 and E7 of the optical axis E of the laser beam are maintained in parallel to the scanning direction of the focal point of the laser beam. On the other hand, when forming the region β of the modified region corresponding to the first micro-hole 304, the direction E8 of the optical axis E of the laser beam is maintained to be vertical to the scanning direction of the focal point of the laser beam.

By adjusting the directions E7 to E9 of the optical axis E of the laser beam in this way, it is possible to form the modified region corresponding to the micro-hole of the interposer substrate 310 by irradiating the laser beam from only the first principal surface 302 side of the substrate 301.
A combination of the angles θ and ϕ of the directions E7 to E9 of the optical axis E of the laser beam is (θ, ϕ)=(0°, 0°) for the directions E7 and E9 and is (θ, ϕ)=(0°, 20°) for the direction E8.

When the directions E7 to E9 of the optical axis E of the laser beam are adjusted in this way, since the directions of the optical axis of the laser beam with respect to the scanning direction of the focal point of the laser beam are different in the respective regions α to γ, the degree of modification of the regions α and γ is different from the degree of modification of the region β. That is, the etching rate of the regions α and γ is different from the etching rate of the region β.
However, only the etching rate in the region β is substantially uniform, and the etching rate in the regions α and γ is substantially uniform independently from the region β. Thus, it is easy to predict the etching rate of the modified region corresponding to the first micro-hole 304, and the first micro-hole 304 can be formed by controlling the degree of etching with high accuracy.

Therefore, in Step A of the microstructure forming method according to the embodiment of the present invention, it is preferable to irradiate the light beam while maintaining the direction of the optical axis of the laser beam to be constant with respect to the scanning direction of the focal point of the laser beam in at least a part of the entire region where the modified region is formed. It is more preferable to irradiate the laser beam while maintaining the direction of the optical axis of the laser beam to be constant with respect to the scanning direction of the focal point of the laser beam in at least a half or more of the entire region where the modified region is formed. It is more preferable to irradiate the laser beam while maintaining the direction of the optical axis of the laser beam to be constant with respect to the scanning direction of the focal point of the laser beam in an entire part of the entire region where the modified region is formed.

Steps B and C described below can be applied to the case of forming the interposer substrates 210 and 310.

### [Step B]

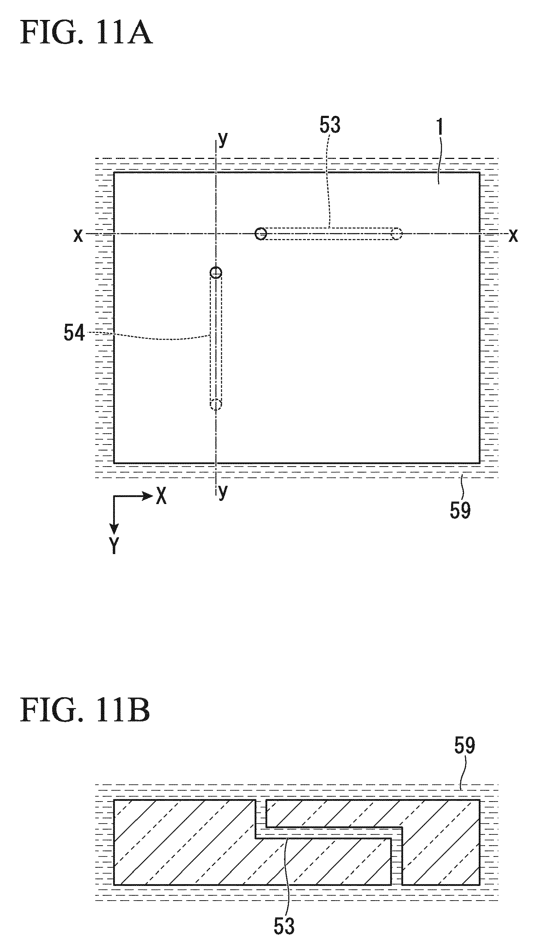

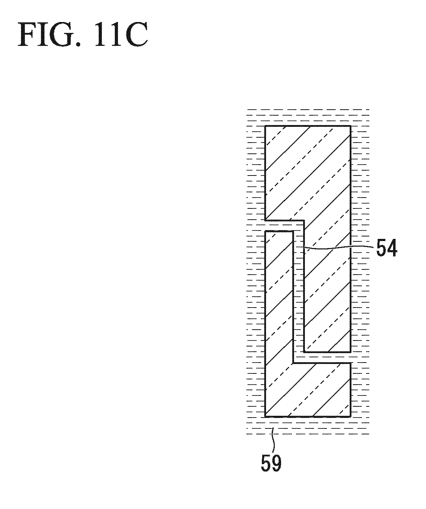

As shown in FIGS. 11A to 11C, by immersing the substrate 1 in which the first modified region 53 and the second modified region 54 are formed in an etching solution (chemical solution) 59 and performing wet-etching, the respective modified regions 53 and 54 are removed from the substrate 1. As a result, the first micro-hole 4 and the second micro-hole 5 are formed in the region where the first modified region 53 and the second modified region 54 are present (FIG 11C). In the present embodiment, glass is used as the material of the substrate 1, and a solution containing 10% by mass of hydrofluoric acid (HF) as the main component is used as the etching solution 59.

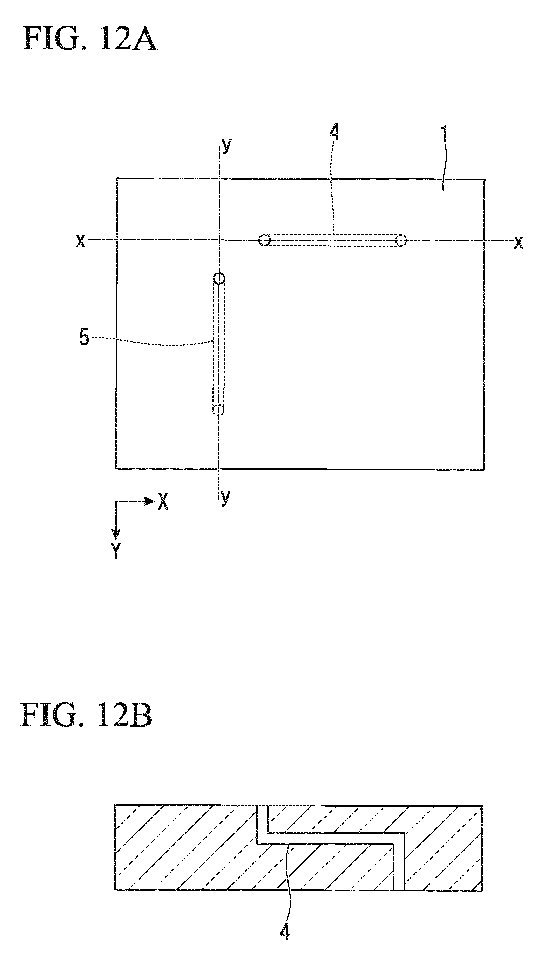

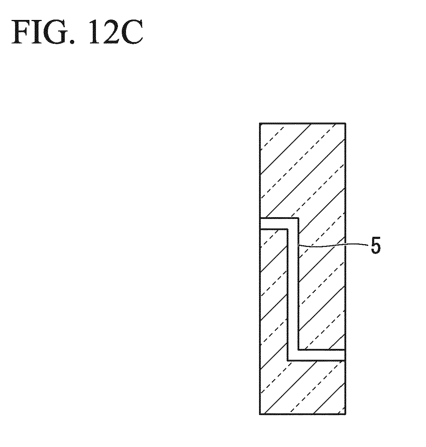

The etching uses a phenomenon in which the first modified region 53 and the second modified region 54 are etched extremely faster than the non-modified regions of the substrate 1. As a result, it is possible to form the respective micro-holes 4 and 5 having shapes corresponding to the shapes of the respective modified regions 53 and 54 (FIGS. 12A to 12C).

The etching solution 59 is not particularly limited, and for example, a solution having hydrofluoric acid (HF) as the main component, or a mixed solution of nitrohydrofluoric acid series in which a suitable amount of nitric acid or the like is added to fluoric acid can be used. Moreover, other chemical solutions may be used depending on the material of the substrate 1.

### [Step C]

The first through-hole interconnection 7 and the second through-hole interconnection 8 are formed in the substrate 1 in which the first micro-hole 4 and the second micro-hole 5 are formed by filling or depositing the electrically conductive substance 6 in the respective micro-holes 4 and 5. Examples of the conductive substance 6 include gold-tin (Au-Sn) and copper (Cu). As a method of filling or depositing the electrically conductive substance 6, a molten metal suction method, a supercritical deposition method, or the like can be used appropriately.

According to Steps A to C above, the interposer substrate 10 shown in FIGS. 1A to 1C is obtained.
Further, a land portion may be formed on the opening portions 9, 13, 14, and 17 of the respective through-hole interconnections 7 and 8 according to the needs. As a method of forming the land portion, a plating method, a sputtering method, or the like can be used appropriately.

### <Method of Manufacturing Surface Interconnection Substrate 30>

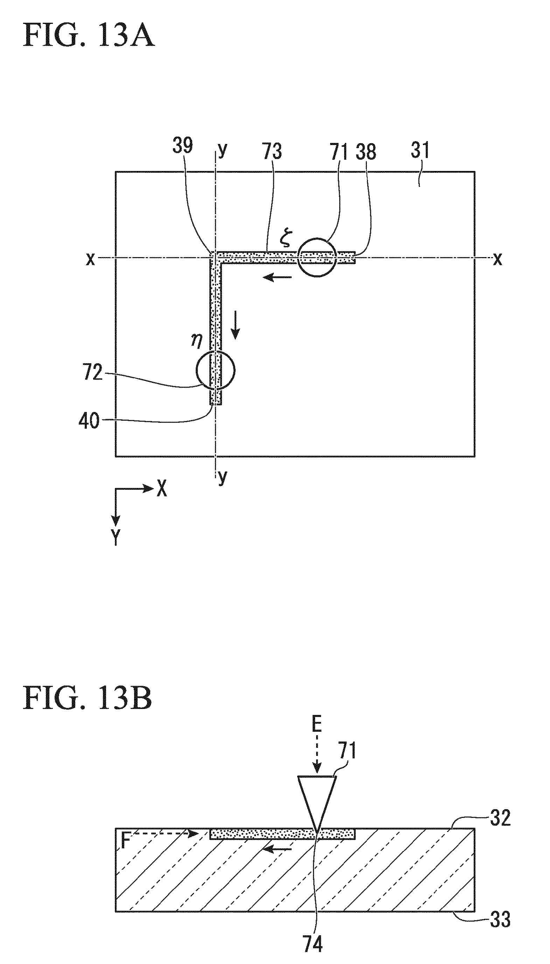

Next, a method of manufacturing the surface interconnection substrate 30 will be described with reference to FIGS. 11A to 13C as another example of the method of forming the micro-hole and the micro-groove in the interconnection substrate according to the embodiment of the present invention.
Here, FIGS. 13A to 15C are plan views and cross-sectional views of the substrate 31 used for manufacturing the surface interconnection substrate 30. Among the drawings, FIGS. 13A, 14A, and 15A are plan views of the substrate 31, and FIGS. 13B, 13C, 14B, 14C, 15B, and 15C are cross-sectional views of the substrate 31 taken along the lines x-x and y-y of the respective plan views.

### [Step A]

First, as shown in FIGS. 13A to 13C, the substrate 31 is irradiated with the a first laser beam 71 and a second laser beam 72 to form a first modified region 73, in which the material of the substrate 31 is modified, in a portion near the surface of the first principal surface 32 of the substrate 31. The first modified region 73 is formed in a region where the first surface interconnection 37 is formed. The first laser beam 71 and the second laser beam 72 are circularly polarized beams or elliptically polarized beams.

Examples of the material of the substrate 31 include an insulator such as glass or sapphire and a semiconductor such as silicon (Si). Since these materials have a linear expansion coefficient that is close to that of a semiconductor device, the interposer substrate or the surface interconnection substrate can be connected to the semiconductor device using solder or the like with no positional shift and high accuracy. Among these materials, an insulating glass is preferred. When glass is used as the material of the substrate, it is possible to obtain an advantage that it is not necessary to form an insulating layer on the inner wall surfaces of the micro-hole and the micro-groove, and there is no inhibiting factor of high-speed transmission such as the presence of a stray capacitance component.
The thickness of the substrate 31 can be appropriately set, for example, in the range of approximately 150 µm to 1 mm.

The first laser beam 71 and the second laser beam 72 are irradiated on the first principal surface 32 side of the substrate 31, and a first focal point 74 and a second focal point 75 converge at a desired position near the surface of the substrate 31. The material of the substrate 31 is modified at the converging position of the respective focal points 74 and 75.
Thus, the positions of the respective focal points 74 and 75 are sequentially shifted and scanned (moved) while irradiating the respective laser beams 71 and 72 so that the respective focal points 74 and 75 converge over the entire region where the first micro-groove 34 is formed. In this way, it is possible to form the first modified region 73.

The respective laser beams 71 and 72 may be irradiated on the first principal surface 32 side and/or the second principal surface (the other principal surface) 33 side of the substrate 31 and may be irradiated on the side surfaces of the substrate 31. It is preferable to irradiate the laser beam from only both principal surfaces 32 and 33 side because it is easier to do so. The angle between the optical axis E of each of the incident laser beams 71 and 72 and the substrate 31 is set to a predetermined angle. The respective laser beams 71 and 72 may be irradiated sequentially using a single laser beam and may be irradiatedly simultaneously using a plurality of laser beams.

Moreover, the example of the direction of scanning the focal points 74 and 75 of the respective laser beams 71 and 72 includes a single-stroke direction where the focal points are scanned in the order of the region ζ and the region η as indicated by an arrow depicted by a solid line that extends along the first modified region 73 shown in FIG 13A. That is, the arrow indicates that the respective focal points 74 and 75 are scanned in such a manner that the first laser beam 71 scans from the position corresponding to the first end portion 38 of the first modified region 73 to the position corresponding to the bent portion 39, and the second laser beam 72 scans from the position corresponding to the bent portion of the first modified region 73 to the position corresponding to the second end portion 40. In this case, it is preferable to perform one-stroke scanning in the direction indicated by the arrow from the perspective of manufacturing efficiency.

The angle between the optical axis E of the laser beam and the focal point scanning direction (the extension direction of the modified region) can be defined using angles θ and ϕ as shown in FIG 7. That is, in an orthogonal coordinate system of the three axes xyz of FIG 7, when the positive direction of the x-axis is the focal point scanning direction, the optical axis E (indicated by arrow E) of the laser beam is defined by the angle θ with respect to the positive direction of the x-axis and the angle ϕ with respect to the positive direction of the z-axis. In FIG 7, an arrow e indicates a projection of the optical axis E (the laser beam scanning direction) on the x-y plane.

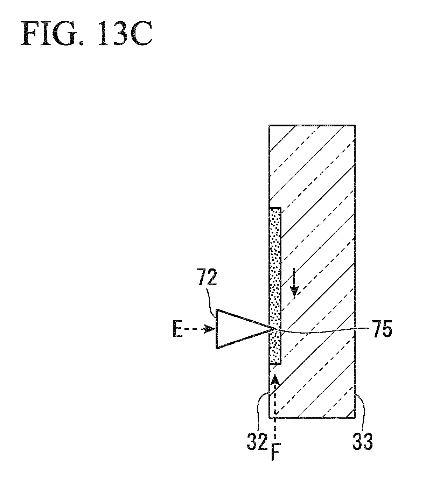

In FIG 13B, the direction of the optical axis E of the first laser beam 71 is vertical to the scanning direction (the extension direction of the region ζ of the first modified region 73) of the first focal point 74, and the angles θ and ϕ are 0°.
Similarly, in FIG 13C, the direction of the optical axis E of the second laser beam 72 is vertical to the scanning direction (the extension direction of the region η of the first modified region 73) of the second focal point 75, and the angles θ and ϕ are 0°.

When forming the first modified region 73, it is preferable to irradiate the regions ζ and η with a laser beam while maintaining the direction of the optical axis E of the respective first and second laser beams 71 and 72 in a certain direction with respect to the scanning direction of the respective focal points 74 and 75.
Here, "maintaining the direction of the optical axis of the laser beam in a certain direction with respect to the scanning direction of the focal point" means maintaining the relative positional relationship between the direction of the optical axis E and the scanning direction of the focal point to be constant and means fixing the angles θ and ϕ to optional specific angles.

As indicated by the arrow E depicted by a broken line in FIGS. 13B and 13C, when scanning is performed in the order of the region ζ and the region η to form the first modified region 73 while maintaining the direction of the optical axis E of the respective laser beams 71 and 72 to be vertical to the scanning direction of the respective focal points 74 and 75, the respective laser beams 71 and 72 are irradiated in a direction vertical to the first principal surface 32 of the substrate 31.

By irradiating the laser beam while maintaining the direction of the optical axis of the laser beam in a certain direction (for example, a vertical direction) to the scanning direction of the focal point in this way, it is possible to suppress the easily etched area and the difficultly etched area from being formed in a banded form in the regions and η of the formed first modified region 73 and to make the modified state uniform. As a result, the etching rate of the regions and η can be made uniform in the subsequent etching step.

Moreover, by setting the angles θ and ϕ of the first laser beam 71 to be the same as the angles θ and ϕ of the second laser beam 72, the modified state of the region ζ in the first modified region 73 and the modified state of the region η can be made uniform. As a result, the etching rate of the ζ in the subsequent etching step can be made approximately the same as the etching rate of the region η, and the first micro-groove 34 can be formed in a shape with high accuracy.

The angles θ and ϕ of the respective laser beams 71 and 72 are not limited to 0°, and the angles θ and ϕ can be independently set to an optional angle.
For example, a combination (θ, ϕ) of the angles θ and ϕ is set to (0°, 90°), the direction of the optical axis E of the laser beam is parallel to the scanning direction (the extension direction of the modified region) of the focal point.

As indicated by an arrow F depicted by a broken line in FIGS. 13B and 13C, when scanning is performed in the order of the region ζ and the region η to form the first modified region 73 while maintaining the direction of the optical axis F of the respective laser beams 71 and 72 in parallel to the scanning direction of the respective focal points 74 and 75, the respective laser beams 71 and 72 are irradiated in a direction vertical to the side surface of the substrate 31.

By irradiating the laser beam while maintaining the direction of the optical axis of the laser beam in parallel to the scanning direction of the focal point in this way, it is possible to suppress the easily etched area and the difficultly etched area from being formed in a banded form in the regions ζ and η of the formed first modified region 73 and to form a pattern in which both areas are mixed in an indefinite form so as to extend in the scanning direction.
Moreover, since the modified state of the regions α to γ of the modified region can be made uniform, the etching rate of the regions α to γ can be made uniform in the subsequent etching step.

In the microstructure forming method according to the embodiment of the present invention, the laser beam may be irradiated while maintaining the direction of the optical axis of the laser beam in a certain direction with respect to the scanning direction of the focal point, and the laser beam may be irradiated without maintaining the direction of the optical axis in a certain direction.
When the laser beam is irradiated while maintaining the direction of the optical axis of the laser beam in a certain direction with respect to the scanning direction of the focal point when scanning the entire region corresponding to the modified region, as described above, the modified state can be made uniform over the entire region of the modified region.

On the other hand, even when the laser beam is irradiated without maintaining the direction of the optical axis in a certain direction, the modified state does not change extremely over the entire region of the modified region but remains approximately at the same state although it cannot be said to be uniform, and an extremely large fluctuation does not occur in the etching rate in the subsequent etching step.

The laser beam used in the microstructure forming method according to the embodiment of the present invention is a circularly polarized beam or an elliptically polarized beam. The circularly polarized beam may be a right circularly polarized beam or a left circularly polarized beam. The elliptically polarized beam may be a right elliptically polarized beam or a left elliptically polarized beam. The elliptically polarized beam is preferably an elliptically polarized beam that is close to a circularly polarized beam in order to achieve a sufficient advantage according to the embodiment of the present invention.
Such a circularly polarized laser beam or such an elliptically polarized laser beam can be obtained, for example, by passing a femtosecond laser beam through an existing appropriate polarizer.

By scanning the focal points 74 and 75 of the circularly polarized laser beams or elliptically polarized laser beams 71 and 72 on the region corresponding to the modified region 73, it is possible to form the modified region 73 having a diameter of several µm to several tens of µm, for example.
Moreover, by controlling the converging position of the focal points 74 and 75, it is possible to form the modified region 73 having a desired shape.

The modified region corresponding to the first micro-hole 234 of the surface interconnection substrate 230 can be formed in a manner similarly to the modified region 73 corresponding to the first micro-groove 34 of the surface interconnection substrate 30.
By forming the modified regions 239 corresponding to the inflected portions of the surface interconnection 237 of the surface interconnection substrate 230 using irradiation of a circularly polarized laser beam or an elliptically polarized laser beam, it is possible to suppress the easily etched area and the difficultly etched area from being formed in a banded form in the modified region corresponding to the inflected portion and to smoothly form the modified region so as to correspond to the shape of the inflected portion. Thus, the degree of ease of etching of the modified region corresponding to the inflected portion can be made to be approximately the same as the degree of ease of etching of the other modified regions corresponding to the straight-line portions. As a result, it is possible to form the microstructure having the inflected portion in a shape with high accuracy.
Steps B and C described below can be applied to the case of forming the surface interconnection substrate 230.

### [Step B]

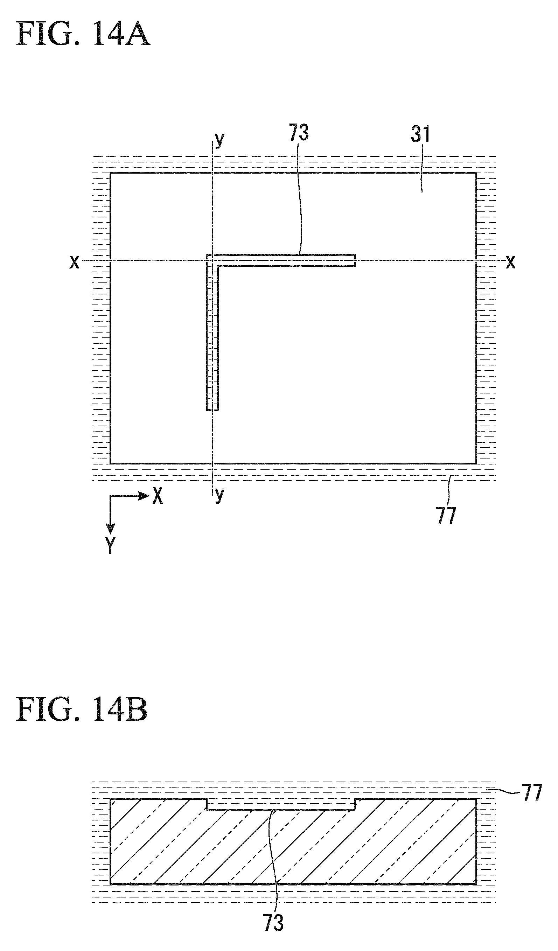

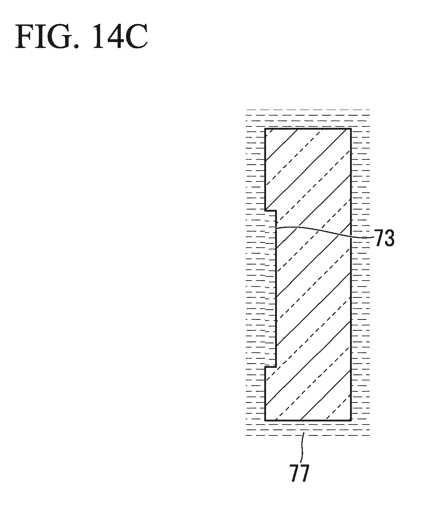

As shown in FIGS. 14A to 14C, by immersing the substrate 31 in which the first modified region 73 is formed in an etching solution (chemical solution) 77 and performing wet-etching, the first modified region 73 is removed from the substrate 31. As a result, the first micro-groove 34 is formed in the region where the first modified region 73 is present (FIGS. 14A to 14C). In the present embodiment, glass is used as the material of the substrate 31, and a solution containing 10% by mass of hydrofluoric acid (HF) as the main component is used as the etching solution 77.

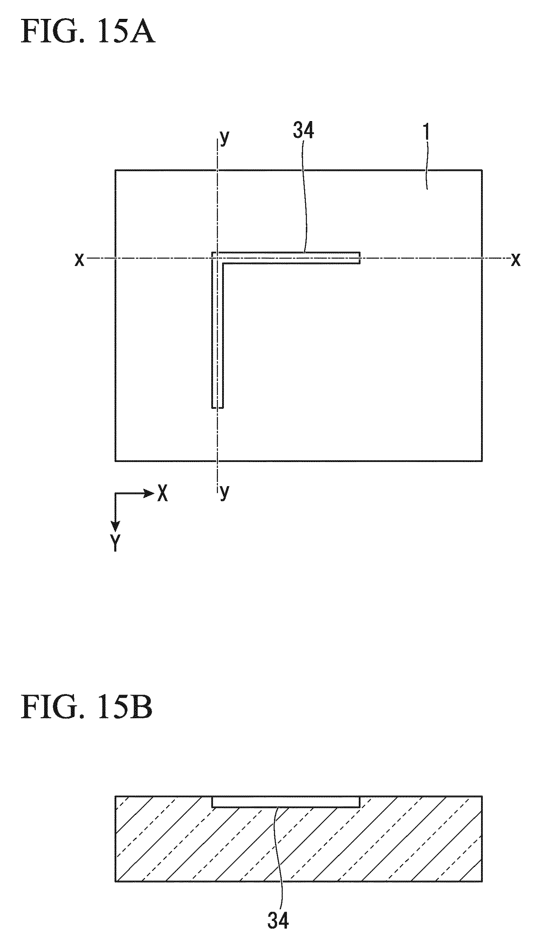

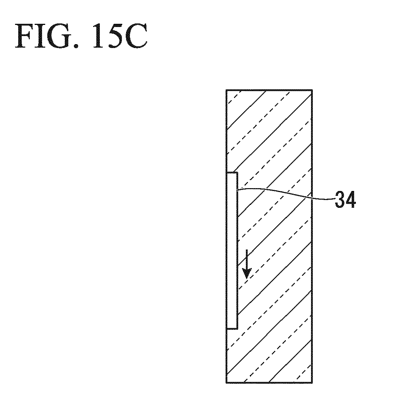

The etching uses a phenomenon in which the first modified region 73 is etched extremely faster than the non-modified regions of the substrate 31. As a result, it is possible to form the first micro-groove 34 having a shape corresponding to the shape of the first modified region 73 (FIGS. 15A to 15C).

The etching solution 77 is not particularly limited, and for example, a solution having hydrofluoric acid (HF) as the main component, or a mixed solution of nitrohydrofluoric acid series in which a suitable amount of nitric acid or the like is added to fluoric acid can be used. Moreover, other chemical solutions may be used depending on the material of the substrate 31.

### [Step C]

The first surface interconnection 37 is formed in the substrate 31 in which the first micro-groove 34 is formed by filling or depositing the electrically conductive substance 36 in the first micro-groove 34. Examples of the conductive substance 36 include gold-tin (Au-Sn) and copper (Cu).
As an example of a method of filling or depositing the electrically conductive substance 36, the following method may be used. That is, first, a film formed of the electrically conductive substance 36 is formed on the entire upper surface of the substrate 31 according to a sputtering method to fill or deposit the electrically conductive substance 36 in the micro-groove 34. Subsequently, after performing masking by forming a resist film on the micro-groove 34, performing dry etching on the upper surface of the substrate 31 to remove the film formed of the electrically conductive substance 36 from a non-masked region. Finally, the masking resist is removed.

According to Steps A to C above, the surface interconnection substrate 30 shown in FIGS. 4A to 4C is obtained.
Further, a land portion may be formed on a predetermined position (for example, the first end portion 38 or the second end portion 40) of the surface interconnection 34 according to the needs. As a method of forming the land portion, a plating method, a sputtering method, or the like can be used appropriately.

### <Laser Irradiation Device>

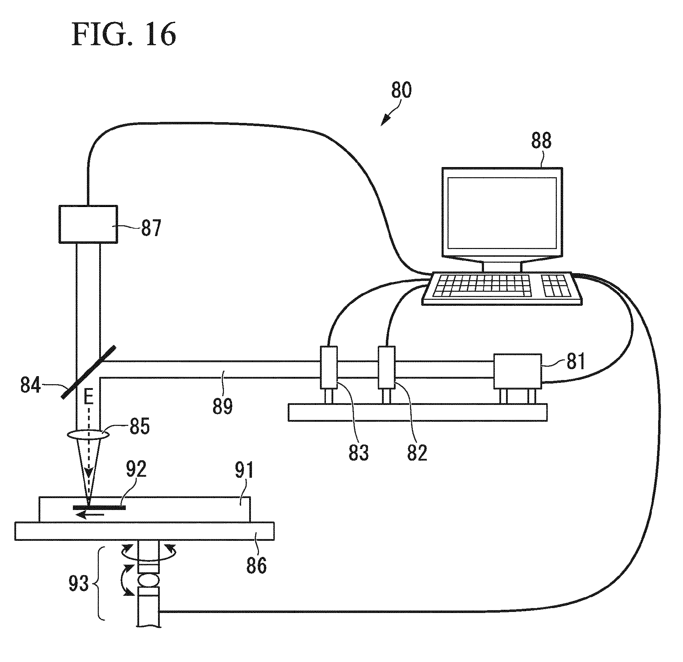

Next, a laser irradiation device 80 will be described as an example of a laser irradiation device that can be used for the microstructure forming method in the interconnection substrate according to the embodiment of the present invention (FIG 16).
The laser irradiation device 80 includes at least a laser beam source 81, a shutter 82, a polarizer 83, a half mirror 84, an objective lens 85, a substrate stage 86, a CCD camera 87, a control computer 88, and a substrate stage control shaft 93.

The laser irradiation device 80 includes a unit (means) that irradiates a region of a substrate 91, in which a hole-shaped or groove-shape microstructure is to be formed, with a circularly or elliptically polarized laser beam 89 having a pulse width of which the pulse duration is on the order of picoseconds or shorter, and performs laser irradiation while maintaining the optical axis of the laser beam 89 in a certain direction with respect to the scanning direction of the focal point when scanning the focal point at which the laser beam 89 converges to form a modified region 92.

In FIG 16, the substrate 91 placed on the substrate stage 86 is irradiated with the laser beam 89, whereby the modified region 92 is formed. The direction of an arrow that extends along the modified region 92 is the scanning direction of the focal point of the laser beam 89. The direction (indicated by an arrow E depicted by a broken line) of the optical axis of the laser beam 89 is vertical to the scanning direction.

As the laser irradiation device 80, an existing laser irradiation device capable of irradiating the laser beam 89 having a pulse width of which the pulse duration is on the order of picoseconds or shorter can be used.

The polarizer 83 is controlled by the control computer 88 and can adjust the polarization of the laser beam 89 to a desired polarization among a right circular polarization, a left circular polarization, a right elliptical polarization, and a left elliptical polarization.

The substrate stage 86 which is one part of the unit can freely adjust the orientation, angle, and movement of the substrate 91 fixed on the substrate stage 86 with the aid of the substrate stage control shaft 93 that is connected to the lower portion of the substrate stage 86. Thus, according to a change of the scanning direction of the focal point, the substrate stage 86 changes the direction of the optical axis E of the laser beam 83 so as to be in a certain direction with respect to the changed scanning direction.

The substrate stage 86 that includes the substrate stage control shaft 93 can freely adjust the orientation, angle, and movement of the substrate 91 synchronized with the change of the scanning direction of the focal point. For example, when the scanning direction of the focal point of the laser beam 83 is changed from the direction parallel to the principal surface of the substrate 91 to the direction (the thickness direction of the substrate 91) vertical to the principal surface of the substrate 91, the substrate stage 86 is tilted by 90° so that the laser beam 89 is incident from the side surface of the substrate 91 rather than moving the direction of the optical axis E of the laser beam 89. According to the above method, the direction of the optical axis E of the laser beam 89 can be maintained to be constant with respect to the changed scanning direction of the focal point.
Moreover, instead of the above method, by a method of switching the optical path of the laser beam 89 with the substrate stage 86 fixed so that the laser beam 89 is incident from the side surface of the substrate 91, the direction of the optical axis E of the laser beam 89 can be maintained to be constant with respect to the changed scanning direction of the focal point.

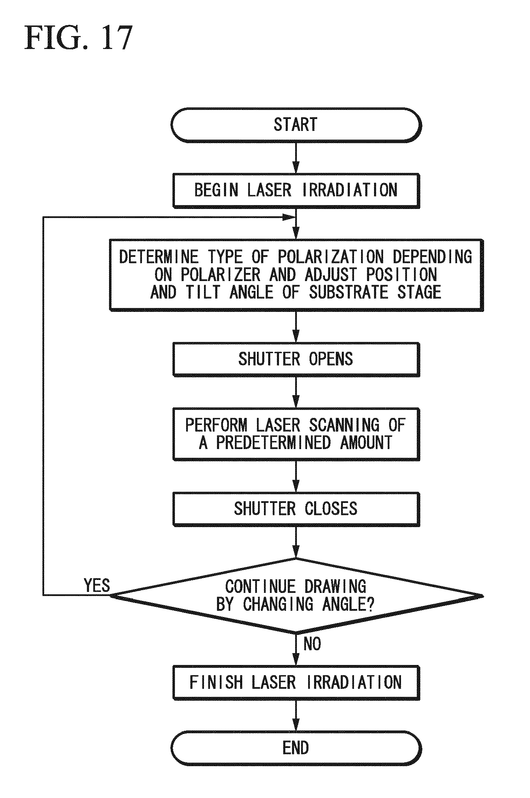

An example of an interconnection substrate forming method according to an embodiment of the present invention that uses the laser irradiation device 80 will be described with reference to the flowchart of FIG 17.
First, the substrate 91 is fixed to the substrate stage 86, and the type of the polarization of the laser beam 89 is adjusted using the polarizer 83. In this state, information such as the scanning direction or a scanning region of the laser beam 89 is created as a program that defines a series of processes. When the process starts, the position and the tilt angle of the substrate stage 86 are adjusted so that the direction of the optical axis E of the laser beam 89 is maintained in a certain direction with respect to the scanning direction of the focal point of the laser beam 89. After that, the shutter 82 opens, and a predetermined amount of the laser beam 89 having a wavelength transparent to the substrate 91 is irradiated at a predetermined position of the substrate 91.

In general, since the electrons of the material of the substrate 91 are not energized by the bandgap, the laser beam 89 passes through the substrate 91. However, when the number of photons of the laser beam 89 increases too much, multiphoton absorption occurs, and the electrons are energized, whereby a modified region is formed.

When the predetermined laser irradiation that is programmed in advance is finished, the shutter 82 is closed. Subsequently, when the laser drawing is continued while changing the scanning direction of the focal point of the laser beam 89, the position and the tilt angle of the substrate stage 86 are adjusted again, and the process is repeatedly performed. When the drawing ends, the laser irradiation ends, and the process is completed.

In the above method, by adjusting the substrate stage 86, the relative direction of the optical axis E of the laser beam 89 with respect to the scanning direction of the focal point of the laser beam 89 is controlled.
As another method, as described above, rather than adjusting the substrate stage 86, by controlling the optical path of the laser beam 89 using a mirror or an objective lens (not shown) provided separately to irradiate the laser beam 89 on the substrate 91 at a desired incidence angle, it is possible to control the relative direction of the optical axis E of the laser beam 89 with respect to the scanning direction of the focal point of the laser beam 89 to be in a desired direction.
Moreover, by using both the adjustment of the substrate stage 86 and the control of the optical path of the laser beam 89, the relative direction of the optical axis E of the laser beam 89 with respect to the scanning direction of the focal point of the laser beam 89 may be controlled to be in a desired direction.

### <Relationship Between Orientation of Linear Polarization With Respect to Laser Scanning Direction and Etching Rate>

The present inventors have investigated the problem of the conventional motion information, in that the etching rate of the modified region fluctuates greatly depending on the position of the formed modified region in the substrate and have found that the laser beam which is a linear polarized beam is the major cause of the problem.
That is, the present inventors have found that the orientation (the orientation of polarization) of the linear polarization of the laser beam with respect to the scanning direction of the focal point of the laser beam in the modified region forming step (Step A) has a great influence on the wet-etching rate in the subsequent etching step (Step B).
As the result of further concerted study, the present inventors have finalized the embodiment of the present invention in which a circularly polarized beam or an elliptically polarized beam is used as the laser beam. Hereinafter, the problem occurring when the linearly polarized beam is used will be described.

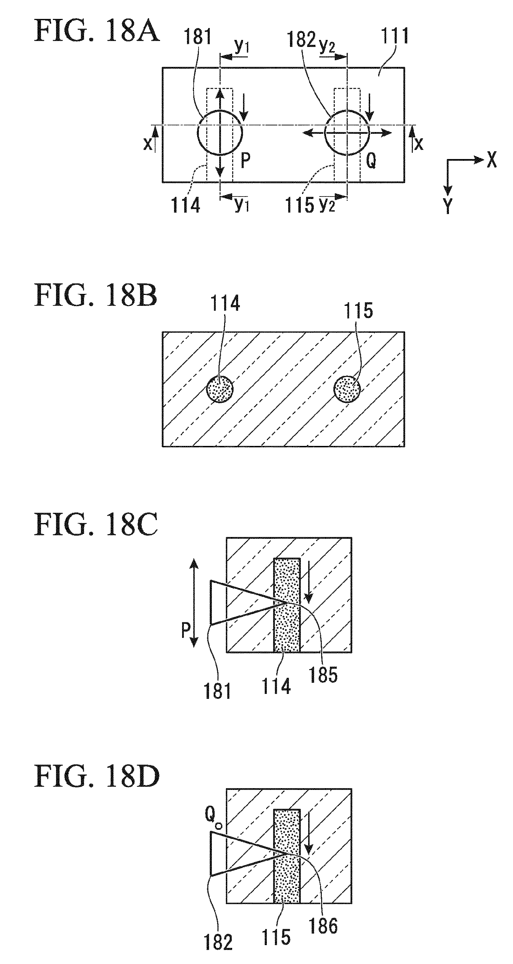

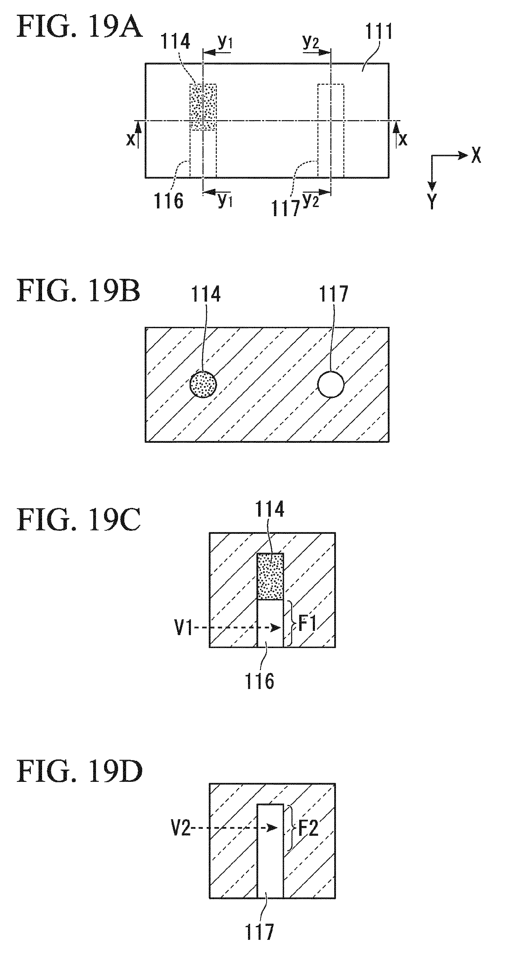

FIGS. 18A to 18D and FIGS. 19A to 19D are plan views and cross-sectional views of a substrate 111. In the drawings, FIGS. 18A and 19A are plan views of the substrate 111. FIGS. 18B and 19B, FIGS. 18C and 19C, and FIGS. 18D and 19D are cross-sectional views of the substrate 111, respectively, taken along the lines x-x, yl-yl, and y2-y2 of FIGS. 18A and 19A.

In the modified region forming step (Step A), two modified regions corresponding to micro-holes are formed by changing the orientation of the linear polarization of the irradiation laser (FIGS. 18A to 18D).
A glass substrate is used as the substrate 111, and a femtosecond laser (linearly polarized laser) is used as the laser beam source.

First, a focal point 185 of a first laser beam 181 is scanned with the focal point 185 converging on a region of the substrate 111 where a first modified region 114 is to be formed. The scanning direction of the focal point 185 corresponds to the longitudinal direction (Y-direction) of the substrate 111, and the scanning is performed in a single stroke as indicated by an arrow that extends along the first modified region 114. In this case, the first modified region 114 is formed in a state where the orientation P of the linear polarization of the first laser beam 181 is set to the Y-direction and maintained to be in parallel to the scanning direction of the focal point 185.

Moreover, a focal point 186 of a second laser beam 182 is scanned with the focal point 186 converging on a region where a second modified region 115 is to be formed. The scanning direction of the focal point 186 corresponds to the longitudinal direction (Y-direction) of the substrate 111, and the scanning is performed in a single stroke as indicated by an arrow that extends along the second modified region 115. In this case, the second modified region 115 is formed in a state where the orientation Q of the linear polarization of the second laser beam 182 is set to the lateral direction (X-direction) of the substrate 111 and maintained to be vertical to the scanning direction of the focal point 186.
A circle depicted near the second laser beam 182 shown in FIG 18D indicates that the orientation Q of the linear polarized beam is a front and depth direction of the sheet.

Subsequently, by immersing the substrate 111 in a HF solution (10% by mass) and performing wet-etching for a predetermined time, the first modified region 114 and the second modified region 115 are removed from the substrate 111, and the first micro-hole 116 and the second micro-hole 117 that are non-through holes (vias) are formed (FIGS. 19A to 19D).
When the depths of the respective formed micro-holes are measured, the depth of the first micro-hole 116 is approximately half the depth of the second micro-hole 117. That is, the ratio of the etching rate of the first micro-hole 116 to the etching rate of the second micro-hole 117 is approximately 1/2.

When the inner wall surfaces of an etched region F1 of the first micro-hole 116 and an etched region F2 of the second micro-hole 117 shown in FIGS. 19C and 19D are observed from the upper surface (the direction indicated by arrows V1 and V2) of the substrate 111 which is the irradiation direction of the laser beam, banded uneven profiles (stria marks) are formed in different directions.

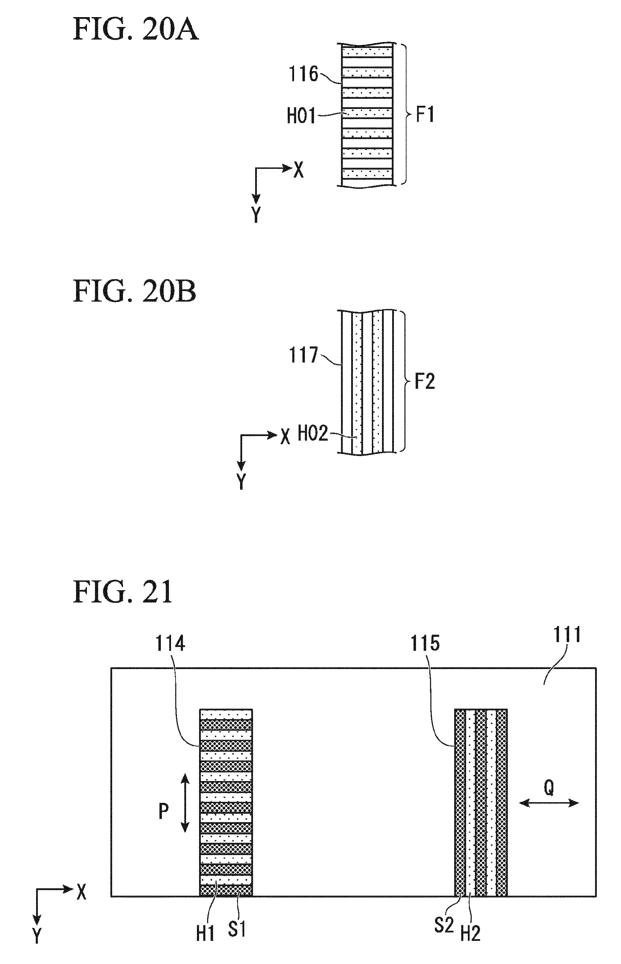

The extension direction of the banded uneven profile H01 of the first micro-hole 116 is vertical to the extension direction of the first micro-hole 116 and is also vertical to the orientation P of the linear polarization of the first laser beam 181 (FIG 20A).
The extension direction of the banded uneven profile H02 of the second micro-hole 117 is parallel to the extension direction of the second micro-hole 117 and is vertical to the orientation Q of the linear polarization of the second laser beam 182 (FIG 20B).
The number of uneven profiles shown in FIGS. 20A and 20B is not limited to a specific number. The number can be changed by controlling the use condition of the laser beam and the degree of linear polarization of the laser beam.

From these results, when the first modified region 114 formed in the substrate 111 before etching is seen from the upper surface of the substrate 111 in the irradiation direction of the first laser beam 181, it can be understood that an easily etched area S1 (where the etching rate is high) and a difficultly etched area H1 (where the etching rate is low) are alternately formed in a direction vertical to the scanning direction (Y-direction) of the first laser beam 181 and vertical to the orientation P (Y-direction) of the linear polarization of the first laser beam 181 (FIG 21).

Moreover, when the second modified region 115 is seen from the upper surface of the substrate 111 in the irradiation direction of the second laser beam 182, it can be understood that an easily etched area S2 (where the etching rate is high) and a difficultly etched area H2 (where the etching rate is low) are alternately formed in a direction parallel to the scanning direction (Y-direction) of the second laser beam 182 and vertical to the orientation Q (X-direction) of the linear polarization of the second laser beam 182 (FIG 21).
The number of areas shown in FIG 21 is not limited to a specific number. The number can be changed by controlling the use condition of the laser beam and the degree of linear polarization of the laser beam.

From the above, the following can be understood.
In the first modified region 114, when the etching solution progresses to the interior of the substrate 111, the progress of the etching solution is obstructed by the plurality of difficultly etched areas H1. On the other hand, in the second modified region 115, when the etching solution progresses to the interior of the substrate 111, the easily etched areas S2 are removed first, and the etching solution reaches deep into the second modified region 115. After that, the plurality of difficultly etched areas H2 are simultaneously etched in parallel by the etching solution that has moved to the regions where the areas S2 have already been removed.
For this reason, the etching rate of the first modified region 114 is slower than the etching rate of the second modified region 115, and the etching rate of the second modified region 115 is faster than the etching rate of the first modified region 114.

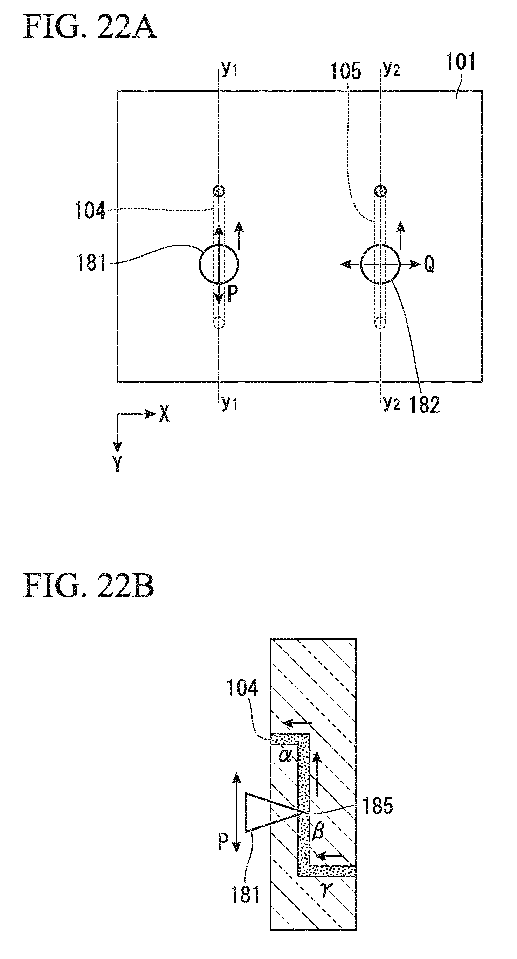

Next, application of the above understanding to the first modified region 104 and the second modified region 105 with more complicated shapes that are arranged in a separate substrate 101 shown in FIGS. 22A to 22C will be described.
FIGS. 22A to 25C are plan views and cross-sectional views of the substrate 101. In the drawings, FIGS. 22A, 23, and 25A are plan views of the substrate 101. FIGS. 22B, 24A, and 25B and FIGS. 22C, 24B, and 25C are cross-sectional views of the substrate 101, respectively, taken along the lines y1-y1 and y2-y2 of FIGS. 22A, 23, and 25A.

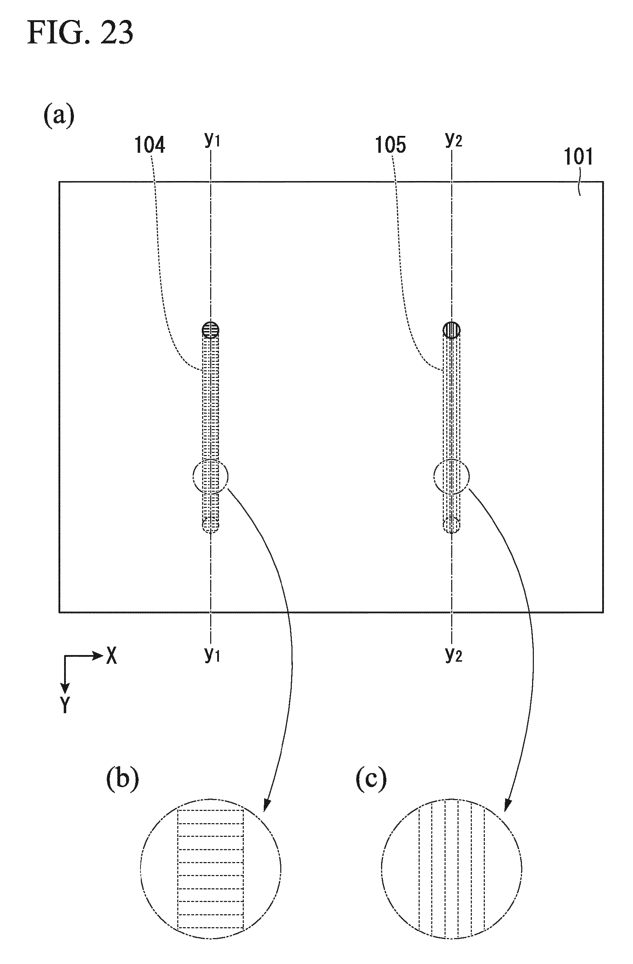

FIG 23 is a plan view of the substrate 101. In the drawing, Part (a) is a plan view of the substrate 101, Parts (b) and (c) are enlarged views of the first modified region 104 and the second modified region 105, respectively.

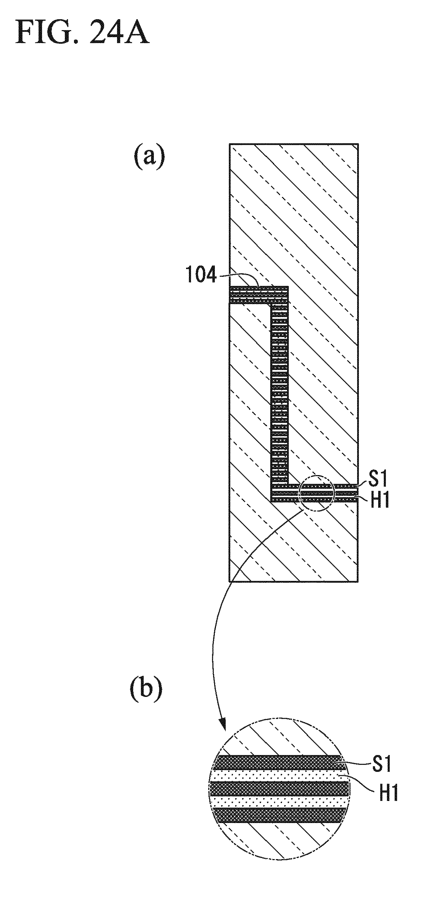

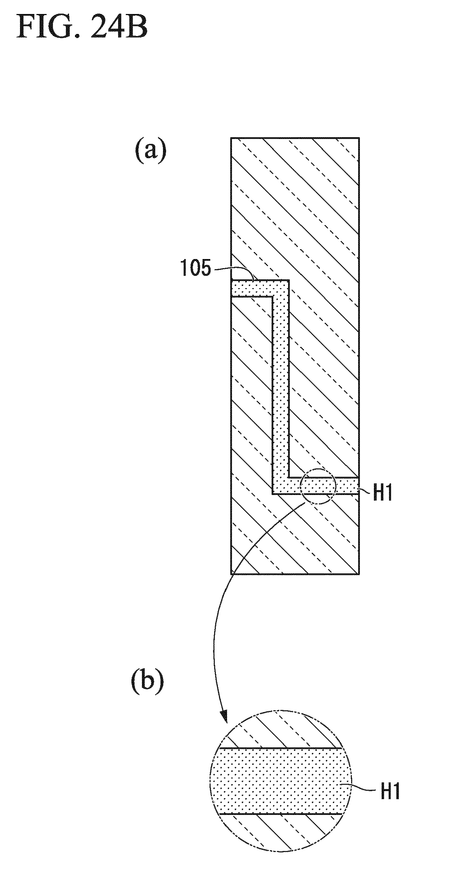

FIGS. 24A and 24B are cross-sectional views respectively taken along the lines y1-y1 and y2-y2 of Part (a) of FIG 23. In the drawings, Part (a) of FIG 24A is a cross-sectional view taken along the line y1-y1 in the plan view of the substrate 101, and Part (b) of FIG 24A is an enlarged view of the cross-sectional view of Part (a). Part (a) of FIG 24B is a cross-sectional view taken alon the line y2-y2 in the plan view of the substrate 101, and Part (c) of FIG 24B is an enlarged view of the cross-sectional view of Part (a).

First, a focal point 185 of a first laser beam 181 is irradiated on the upper surface of the substrate 101 with the focal point 185 of the first laser beam converging on a region of the substrate 101 corresponding to the first modified region 104. The scanning direction of the focal point 185 is the longitudinal direction (Y-direction) of the substrate 101 and the thickness direction of the substrate, and the scanning is performed in a single stroke in the order of a region γ, a region β, and a region α as indicated by an arrow that extends along the first modified region 104. In this case, in the regions γ and α, the modified region 104 is formed while maintaining the orientation P of the linear polarization of the first laser beam 181 to be vertical to the scanning direction (the thickness direction of the substrate 101) of the focal point 185. On the other hand, in the region β, the first modified region 104 is formed while maintaining the orientation P of the linear polarization of the first laser beam 181 in parallel to the scanning direction (Y-direction) of the focal point 185 (FIG 22B).

As a result, in the regions α and γ of the first modified region 104, the easily etched area S1 and the difficultly etched area H1 are formed to extend in parallel along the extension direction (the thickness direction of the substrate) of the first modified region 104. On the other hand, in the region β of the first modified region 104, the easily etched area S1 and the difficultly etched area H1 are formed to be shifted in a direction vertical to the extension direction (Y-direction) of the first modified region 104 (FIGS. 23, 24A, and 24B).
The number of areas shown in FIGS. 24A and 24B is not limited to a specific number. The number can be changed by controlling the use condition of the laser beam and the degree of linear polarization of the laser beam.

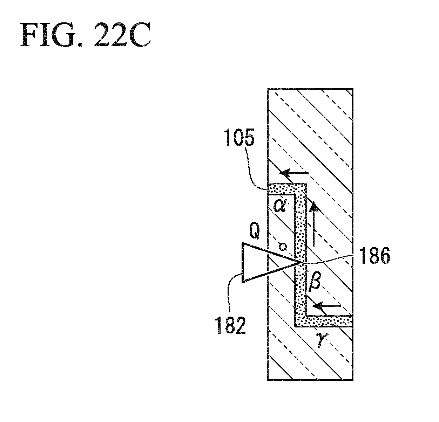

Further, a focal point 186 of the second laser beam 182 is irradiated on the upper surface of the substrate 101 with the focal point 186 of the second laser beam 182 converging on a region of the substrate 101 corresponding to the second modified region 105. The scanning direction of the focal point 186 is the longitudinal direction (Y-direction) of the substrate 101 and the thickness direction of the substrate, and the scanning is performed in a single stroke in the order of a region γ, a region β, and a region α as indicated by an arrow that extends along the second modified region 105. In this case, in all of the regions α to γ, the second modified region 105 is formed while maintaining the orientation Q of the linear polarization of the second laser beam 182 to be vertical to the scanning direction (the Y-direction or the thickness direction of the substrate) of the focal point 186 (FIG 22C).
A circle depicted near the second laser beam 182 shown in FIG 22C indicates that the orientation Q of the linear polarized beam is a front and depth direction of the sheet.

As a result, in all of the areas α, β, and γ of the second modified region 105, the easily etched area S2 and the difficultly etched area H2 are formed to extend in parallel along the extension direction (the Y-direction or the thickness direction of the substrate) of the second modified region 105 (FIGS. 23, 24A, and 24B).

The shapes of the first modified region 104 and the second modified region 105 are the same, the length of the region α is 50 µm, the length of the region β is 200 µm, and the length of the region γ is 50 µm.
Moreover, a glass substrate is used as the substrate 101, and a femtosecond laser (linearly polarized laser) is used as the laser beam source.

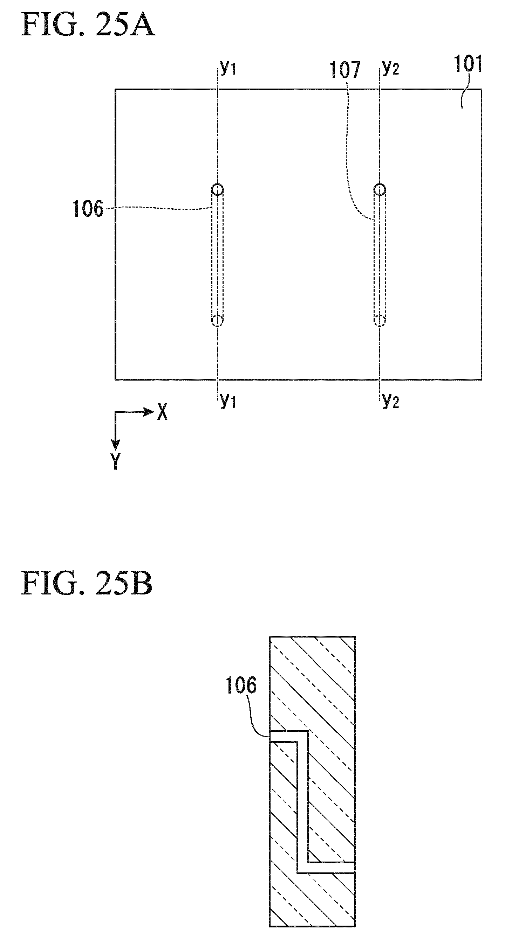

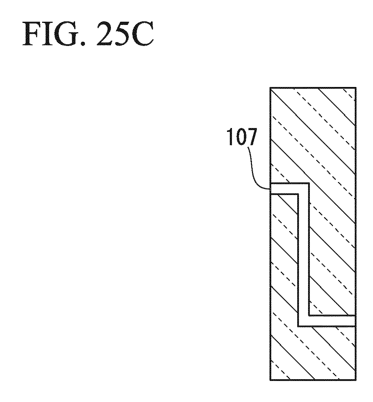

Next, by immersing the substrate 101 in a HF solution (10% by mass) and performing wet-etching for a predetermined time, the first modified region 104 and the second modified region 105 are removed from the substrate 101 and penetrated, and the first micro-hole 106 and the second micro-hole 107 are formed (FIGS. 25A to 25B). In this case, when the penetration time (etching rate) in which the first modified region 104 and the second modified region 105 are removed and penetrated by wet-etching is measured, the ratio of the etching rate of the first modified region 104 to the etching rate of the second modified region 105 is approximately 3/5. This is because although the etching rates of the regions α and γ are the same in any modified regions, the etching rate of the region β in the first modified region 104 is approximately twice as fast as that of the second modified region 105.

From the above, when a modified region is formed in a region where a microstructure such as a micro-hole or a micro-groove is formed, it is obvious that if the laser beam being irradiated is a linear polarized beam, modified regions in which the etching rates are different depending on the orientation of the linear polarized beam with respect to the extension direction of the microstructure are mixed are formed.
When forming a microstructure formed in a substrate in an arbitrary shape, it is necessary to change the extension direction of a modified region to be formed according to the shape of the formed microstructure. In this case, since the relative relationship between the extension direction of the modified region and the orientation of the linear polarization of the laser beam being irradiated changes in various manners, as described above, a modified region in which the etching rate is twice or more faster than that of the other modified regions may be present in the substrate.
On the other hand, in the embodiment of the present invention, since a circularly polarized laser or an elliptically polarized laser is used, it is obvious that it is possible to prevent the easily etched area and the difficultly etched area from being formed in a banded form as seen from the extension direction of the modified region and to suppress the etching rates of the modified regions formed in the substrate from becoming extremetly different.

### INDUSTRIAL APPLICABILITY

The microstructure forming method according to the embodiment of the present invention and the laser irradiation device used in the above method can be suitably used for manufacturing an interconnection substrate that is used in integrated circuits and electronic components.

### DESCRIPTION OF THE REFERENCE SYMBOLS

- 1:: Substrate
- 2:: First principal surface (One principal surface)
- 3:: Second principal surface (The other principal surface)
- 4:: First micro-hole
- 5:: Second micro-hole
- 6:: Electrically conductive substance
- 7:: First through-hole interconnection
- 8:: Second through-hole interconnection
- 9:: Opening portion
- 10:: Interposer substrate
- 11:: Bent portion
- 12:: Bent portion
- 13:: Opening portion
- 14:: Opening portion
- 15:: Bent portion
- 16:: Bent portion
- 17:: Opening portion
- 30:: Surface interconnection substrate
- 31:: Substrate
- 32:: First principal surface (One principal surface)
- 33:: Second principal surface (The other principal surface)
- 34:: First micro-groove
- 36:: Electrically conductive substance
- 37:: First surface interconnection
- 38:: First end portion (One end portion)
- 39:: Bent portion
- 40:: Second end portion (The othe end portion)
- 51:: First laser beam
- 52:: Second laser beam
- 53:: First modified region
- 53s:: Easily etched area
- 53h:: Difficultly etched area
- 54:: Second modified region
- 56:: Focal point
- 57;: Focal point
- 59;: Etching solution
- 61:: First micro-hole
- 62:: Second micro-hole
- 71:: First laser beam
- 72:: Second laser beam
- 73:: First modified region
- 73s:: Easily etched area
- 73h:: Difficultly etched area
- 74:: Focal point
- 75:: Focal point
- 77:: Etching solution
- 80:: Laser irradiation device
- 81:: Laser beam source
- 82:: Shutter
- 83:: Phase retarder
- 84:: Half mirror
- 85:: Objective lens
- 86:: Substrate stage
- 87:: CCD camera
- 88:: Computer
- 89:: Laser beam
- 91:: Substrate
- 92:: Modified region
- 93:: Substrate stage control shaft
- P:: Orientation of linear polarization of first laser beam
- Q:: Orientation of linear polarization of second laser beam
- R:: Orientation of linear polarization of laser beam
- 101:: Substrate
- 102:: First modified region
- 103:: Second modified region
- 105:: Second modified region
- 106:: First micro-hole
- 107:: Second micro-hole
- 111:: Substrate
- 114:: First modified region
- 115:: Second modified region
- 116:: First micro-hole
- 117:: Second micro-hole
- 181:: First laser beam
- 182:: Second laser beam
- 185:: Focal point
- 186:: Focal point
- S1:: Easily etched area
- H1:: Difficultly etched area
- 201:: Substrate
- 202:: First principal surface (One principal surface)
- 203:: Second principal surface (The other principal surface)
- 204:: First micro-hole
- 205:: Second micro-hole
- 206:: Electrically conductive substance
- 207:: First through-hole interconnection
- 208:: Second through-hole interconnection
- 209:: Opening portion
- 210:: Interposer substrate
- 211:: Inflected portion
- 212:: Inflected portion
- 213:: Opening portion
- 214:: Opening portion
- 215:: Inflected portion
- 216:: Inflected portion
- 217:: Opening portion
- 230:: Surface interconnection substrate
- 231:: Substrate
- 232:: First principal surface (One principal surface)
- 233:: Second principal surface (The other principal surface)
- 234:: First micro-groove
- 236:: Electrically conductive substance
- 237:: First surface interconnection
- 238:: First end portion (One end portion)
- 239:: Inflected portion
- 240:: Second end portion (The other end portion)
- 301:: Substrate
- 302:: First principal surface (One principal surface)
- 303:: Second principal surface (The other principal surface)
- 304:: First micro-hole
- 305:: Second micro-hole
- 306:: Electrically conductive substance
- 307:: First through-hole interconnection
- 308:: Second through-hole interconnection
- 309:: Opening portion
- 310:: Interposer substrate
- 311:: Bent portion
- 312:: Bent portion
- 313:: Opening portion
- 314:: Opening portion
- 315:: Bent portion
- 316:: Bent portion
- 317:: Opening portion
- g1:: Third micro-hole
- G1:: Flow channel
- H01:: Banded uneven profile
- H02:: Banded uneven profile

## Claims

1. A microstructure forming method comprising:
a step A of irradiating a region of a substrate, in which a hole-shaped or groove-shaped microstructure is formed, with a circularly or elliptically polarized laser beam having a pulse width of which the pulse duration is on the order of picoseconds or shorter, and scanning a focal point at which the laser beam converges to form a modified region; and
a step B of performing an etching process on the substrate in which the modified region is formed and removing the modified region to form a microstructure.

2. The microstructure forming method according to claim 1,
wherein in the step A, laser irradiation is performed while maintaining a direction of an optical axis of the laser beam in a certain direction with respect to a scanning direction of the focal point.

3. The microstructure forming method according to claim 2,
wherein the certain direction is vertical to the scanning direction of the focal point.

4. The microstructure forming method according to any one of claims 1 to 3,
wherein in the step A, the laser beam is irradiated on only a principal surface side of the substrate.

5. The microstructure forming method according to any one of claims 1 to 4,
wherein an inflected portion is formed in the microstructure.

6. A laser irradiation device comprising:
a unit that irradiates a region of a substrate, in which a hole-shaped or groove-shaped microstructure is formed, with a circularly or elliptically polarized laser beam having a pulse width of which the pulse duration is on the order of picoseconds or shorter and performs laser irradiation while maintaining a direction of an optical axis of the laser beam in a certain direction with respect to a scanning direction of the focal point when scanning the focal point at which the laser beam converges to form a modified region.

7. The laser irradiation device according to claim 6,
wherein the unit is a substrate stage, and
wherein the substrate stage is configured such that according to a change of the scanning direction of the focal point, the direction of the optical axis of the laser beam with respect to the changed scanning direction is in a certain direction.

8. A substrate that is manufactured using the microstructure forming method according to any one of claims 1 to 5.

9. The substrate according to claim 8, wherein a flow channel through which a fluid passes is formed in the substrate.
